# EUROPEAN PATENT APPLICATION

(11) **EP 4 657 526 A2**
(43) Date of publication of application: **03.12.2025**
(21) Application number: 25178591.1
(22) Date of filing: 23.05.2025
(51) Int. Cl.: H01L 25/075, H10H 29/01, H10H 29/03, H01L 23/00, H10H 29/30

(54) **DEVICE FOR MANUFACTURING DISPLAY PANEL**

(30) Priority: 27.05.2024 KR 20240068294
(71) Applicant: Samsung Display Co., Ltd., Yongin-si, Gyeonggi-do 17113 (KR)
(72) Inventor: Han, Jeong Won, Yongin-si, Gyeonggi-do (KR)
(74) Representative: Gulde & Partner

(57) **Abstract**

In an embodiment of the present disclosure, a device for manufacturing a display panel (10) includes a support portion (200) on which a display substrate (20) is mounted. The device includes a mask (310, 1310) defining an opening (312-O, 312-OS) corresponding to a transmission area of the laser beam, and a pressing portion (300) including a pressing member (350) configured to press against the mask (310, 1310). The device includes a laser irradiation portion (500) disposed in a front surface of the support portion (200) and configured to irradiate the display substrate (20) with laser light through the mask (310, 1310). The mask (310, 1310) includes a base layer (311, 1311) configured to transmit laser light, and a light blocking pattern layer (312, 1312) disposed on the base layer (311, 1311) and including the opening (312-O, 312-OS, 1312-OS).

## Description

### BACKGROUND

### 1. Field

The present disclosure relates to a device for manufacturing a display panel.

### 2. Description of the Related Art

Micro LED is an ultra-small inorganic light emitting material that emits light on its own without a backlight. Specifically, micro LED are about one-tenth the length and one-hundredth the area of organic light emitting diode chips. In one example, micro LED may refer to an ultra-small LED whose width, length, and height in the range of about 10 micrometers µm to 100 µm.

Micro LED may be manufactured by growing a plurality of chips in the form of chips on a growth substrate such as, for example, a wafer through an epi process or the like. The micro LED manufactured in this way is usually transferred to a relay substrate and then transferred to a target substrate such that the micro LED may be used as a display module.

The transfer process of the micro LED may use a laser transfer method that transfers the micro LED of the relay substrate to the target substrate by emitting a laser beam, irradiating the back of the relay substrate (a plurality of micro LED are arranged on the front of the relay substrate) with the laser beam.

However, the laser transfer method suffers from the problem that the laser beam irradiating the back of the relay substrate also passes through the areas between the micro-LED and to the outer areas of the relay substrate, thereby irradiating the target substrate in addition to the micro-LED. In an example in which the laser beam is applied to the target substrate, the temperature of the target substrate increases and damage occurs.

### SUMMARY

Aspects and features of embodiments of the present disclosure provide a device for manufacturing a display panel that reflects a laser beam irradiated to a surrounding area other than the micro-LED such that the laser beam is accurately applied to the micro-LED and not to other components, while increasing the uniformity of the pressing force generated by the pressing of the laser light emitting member.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an embodiment, a device for manufacturing a display panel includes a support portion on which a display substrate is mounted, a mask (e.g., a photo mask or a metal mask assembly) defining an opening corresponding to a transmission area of the laser beam, a pressing portion including a pressing member configured to press against the mask, a laser irradiation portion disposed in a front surface of the support portion and configured to irradiate the display substrate with laser light through the mask, wherein the mask includes a base layer configured to transmit laser light, and a light blocking pattern layer disposed on the base layer and including the opening.

The pressing member may include a light transmitting member and an elastic member disposed on the mask and overlapping each other in a thickness direction, may form a closed space between the light transmitting member and the elastic member, and may further include a gas pressure regulator configured to adjust a gas pressure in the closed space.

The elastic member may be disposed on the mask, and the elastic member may be configured to expand based on an increase in gas pressure in the closed space, wherein expansion of the elastic member may press the mask.

The pressing member may further include a gas conduit connected between the gas pressure regulator and the closed space.

The mask may be a photo mask, wherein the photo mask may include the base layer in a form of a transparent flat plate or a translucent flat plate, and the light blocking pattern layer may be disposed on the base layer and may have a light blocking pattern having light blocking properties.

The photo mask may be disposed such that the photo mask faces the display substrate.

The photo mask may be disposed such that the photo mask faces the laser irradiation portion.

The light blocking pattern may include openings formed in an area corresponding to a display area of the display substrate where light emitting elements are arranged.

The light blocking pattern may include openings formed in areas corresponding to light emitting elements arranged on the display substrate.

The device may further include a mounting member attached to an outer surface of the mask to support the mask.

The mask may be a metal mask assembly including a light transmitting layer as the base layer in a form of a transparent plate or a translucent flat plate, and a metal mask as the light blocking pattern layer disposed on the light transmitting layer, having reflectivity, and including the opening.

The opening may be formed in an area corresponding to a display area of the display substrate where light emitting elements are arranged.

The opening may respectively be formed in areas corresponding to light emitting elements arranged on the display substrate.

According to another embodiment, a device for manufacturing a display panel includes a support portion on which a display substrate is mounted, a light transmitting plate disposed on a front surface of the support portion, a pressing member configured to press against the light transmitting plate, a reflective mask defining an opening corresponding to a transmission area of a laser beam incident on the light transmitting plate, and a pressing portion including a light absorbing member configured to absorb laser light reflected by the reflective mask and a laser irradiation portion disposed in front of the light transmitting plate and configured to irradiate the display substrate with the laser light through the light transmitting plate, wherein the reflective mask is disposed such that the reflective mask is inclined with respect to with a top surface of the light transmitting plate, and the light absorbing member is disposed parallel to the reflective mask.

The pressing portion may be disposed between the reflective mask and the light absorbing member, and the pressing portion may further include an optical member configured to focus light toward the light absorbing member.

The opening may be formed in an area corresponding to a display area of the display substrate where light emitting elements are arranged.

The opening may respectively be formed in areas corresponding to light emitting elements arranged on the display substrate.

The opening may include a first side and a second side facing the first side and may be trapezoidal or parallelogram-shaped, and a first angle formed by the first side and one side of the reflective mask and a second angle formed by the second side and the one side of the reflective mask may be different from each other.

The opening may include a first side and a second side facing the first side, wherein a first angle may be formed by the first side and one side of the reflective mask and a second angle may be formed by the second side and the one side of the reflective mask may respectively be the same as angles of an equilateral trapezoid, or the first side and the second side each may have a curvature.

According to an embodiment, a device for manufacturing a display panel includes a support portion on which a display substrate is mounted, a light transmitting plate disposed on the front surface of the support portion, a pressing member configured to press against the light transmitting plate, a reflective mask defining an opening corresponding to a transmission area of a laser beam incident on the light transmitting plate, and a pressing portion including a light absorbing member configured to absorb laser light reflected by the reflective mask and a laser irradiation portion disposed in front of the light transmitting plate and configured to irradiate the display substrate with the laser light through the light transmitting plate, wherein the laser light is divergent light.

According to the display panel manufacturing device according to the embodiments, a laser beam irradiating a surrounding area other than the micro LED is reflected by a reflective member of the light transmitting plate, such that the laser beam is applied precisely to the micro-LED, and the uniformity of the pressing force applied to the micro-LED is increased. Accordingly, manufacturing defects of the target substrate or display panel may be prevented and manufacturing efficiency may be improved.

However, the effects of the present disclosure are not limited to the aforementioned effects, and various other effects are included in the present specification.

All embodiments described in this specification may be advantageously combined with one another to the extent that their respective features are compatible. In particular, the expressions "according to an embodiment," "in an embodiment," "an embodiment of the disclosure provides" etc. mean that the respective features may or may not be part of specific embodiments of the present disclosure.

### BRIEF DESCRIPTION OF THE DRAWINGS

FIG. 1 is a plan view of a display device according to an embodiment.
FIG. 2 is a plan view schematically illustrating the emission area of each pixel according to an embodiment.
FIG. 3 is a plan view schematically illustrating the emission area of each pixel according to another embodiment.
FIG. 4 is a cross-sectional view schematically illustrating the line A - A' of FIG. 2 according to an embodiment.
FIG. 5 is an enlarged view schematically illustrating the first emission area of FIG. 4.
FIG. 6 is a cross-sectional view illustrating the light emitting element of FIG. 5 in detail.
FIG. 7 is a side cross-sectional view schematically illustrating a manufacturing device for a display panel according to an embodiment.
FIG. 8 is a front view schematically illustrating a top surface of the manufacturing device illustrated in FIG. 7.
FIG. 9 is a front view illustrating a shape of the light blocking layer of the photo mask illustrated in FIGS. 7 and 8.
FIGS. 10 to 12 are cross-sectional views of one side illustrating a micro LED transfer method using a manufacturing device in an embodiment.
FIG. 13 is a side cross-sectional view schematically illustrating a manufacturing device for a display panel according to another embodiment.
FIG. 14 is a side cross-sectional view illustrating a micro LED transfer method using a manufacturing device for a display panel FIG. 13.
FIG. 15 is a side cross-sectional view schematically illustrating a manufacturing device for a display panel according to another embodiment.
FIG. 16 is a front view illustrating a shape of the light blocking layer of the photo mask illustrated in FIG. 15.
FIG. 17 is a cross-sectional view of one side illustrating a micro LED transfer method using the manufacturing device illustrated in FIG. 16.
FIG. 18 is a side cross-sectional view schematically illustrating a manufacturing device for a display panel according to another embodiment.
FIG. 19 is a side cross-sectional view illustrating a micro LED transfer method using a manufacturing device for a display panel of FIG. 18.
FIG. 20 is a side cross-sectional view schematically illustrating a manufacturing device for a display panel according to another embodiment.
FIG. 21 is a side cross-sectional view illustrating a micro LED transfer method using a manufacturing device for a display panel of FIG. 20.
FIG. 22 is a side cross-sectional view schematically illustrating a manufacturing device for a display panel according to another embodiment.
FIG. 23 is a side cross-sectional view illustrating a micro LED transfer method using a manufacturing device for a display panel of FIG. 22.
FIG. 24 is a side cross-sectional view schematically illustrating a manufacturing device for a display panel according to another embodiment.
FIG. 25 is a side cross-sectional view illustrating a micro LED transfer method using a manufacturing device for a display panel of FIG. 24.
FIGS. 26a to 26d are cross-sectional views of a metal mask according to an embodiment of FIG. 24.
FIG. 27 is a side cross-sectional view schematically illustrating a manufacturing device for a display panel according to another embodiment.
FIG. 28 is a side cross-sectional view illustrating a micro LED transfer method using a manufacturing device for a display panel of FIG. 27.
FIGS. 29a to 29d are cross-sectional views of a metal mask according to an embodiment of FIG. 27.
FIG. 30 is a side cross-sectional view schematically illustrating a manufacturing device for a display panel according to another embodiment.
FIG. 31 is a side cross-sectional view illustrating a micro LED transfer method using a manufacturing device for a display panel of FIG. 30.
FIG. 32 is a side cross-sectional view schematically illustrating a manufacturing device for a display panel according to another embodiment.
FIG. 33 is a side cross-sectional view illustrating a micro LED transfer method using a manufacturing device for a display panel of FIG. 32.
FIG. 34 is a side cross-sectional view schematically illustrating a manufacturing device for a display panel according to another embodiment.
FIG. 35 is a side cross-sectional view illustrating a micro LED transfer method using a manufacturing device for a display panel of FIG. 34.
FIGS. 36a and 36b are cross-sectional views of s metal mask according to an embodiment of FIG. 33.

### DETAILED DESCRIPTION

The advantages and features of the present disclosure and methods for achieving them will become clear by referring to the embodiments described in detail below along with the accompanying drawings. However, the present disclosure is not limited to the embodiments disclosed below and will be implemented in various different forms. The example embodiments are provided solely to ensure that the disclosure of the present disclosure is complete and to fully inform those skilled in the art of the scope of the disclosure and the disclosure is defined by the scope of the appended claims.

References to an element or layer as being "on" another element or layer include both cases where another layer or element is directly on top of or interposed between the other elements. Throughout the disclosure, like reference numerals refer to like components. The shape, size, ratio, angle, number, and the like disclosed in the drawings to illustrate embodiments are illustrative and the present disclosure is not limited to the details illustrated.

Although first, second, and the like are used to describe various components, these components are of course not limited by these terms. These terms are used to distinguish one component from another. Thus, a first component referred to herein may also be a second component within the technical idea of the present disclosure.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

Each feature of the various embodiments of the present disclosure may be combined or combined with each other partially or entirely and may be technically interlocked and operated in various ways, and each embodiment may be implemented independently of each other or may be implemented together in a related relationship.

Hereinafter, specific embodiments will be described with reference to the attached drawings.

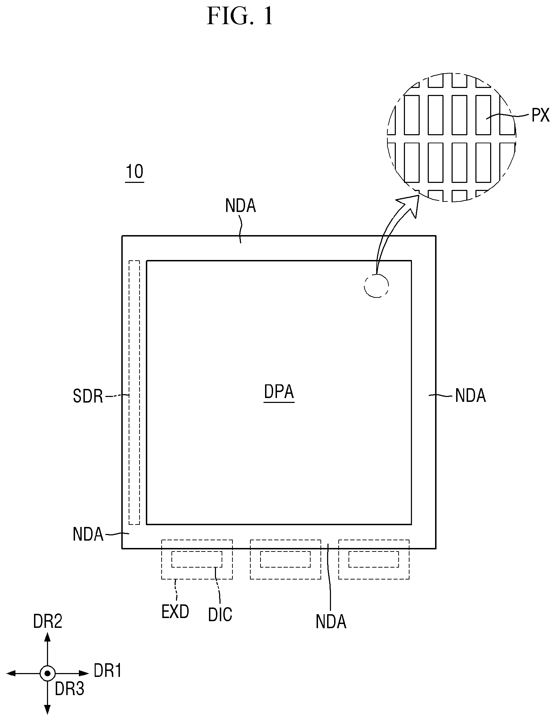

FIG. 1 is a plan view of a display device according to an embodiment.

Referring to FIG. 1, a display device 10 according to an embodiment may be applied to a smartphone, cell phone, tablet PC, personal digital assistant (PDA), portable multimedia player (PMP), television, gaming device, wristwatch-type electronic device, head-mounted display, monitor of a personal computer, laptop computer, car navigation, car instrument panel, digital camera, camcorder, exterior billboard, billboard, medical device, testing device, various consumer electronics such as, for example, refrigerators and washing machines, or Internet of Things device. In this specification, a television is described as an example of a display device, and the TV may have high or ultra-high resolution such as, for example, HD, UHD, 4K, 8K, and the like.

In some aspects, the display device 10 according to an embodiment may be classified into various ways depending on the display method. For example, the classification of display device may include an organic light-emitting display device (OLED), an inorganic light-emitting display device (inorganic EL), a quantum dot light-emitting display device (QED), a micro-LED display device (micro-LED), a nano-LED display device (nano-LED), a plasma display device (PDP), a field emission display device (FED), a cathode ray display device (CRT), a liquid crystal display device (LCD), an electrophoretic display device (EPD), and the like. In the following, a micro LED display device will be described as an example as a display device, and the micro-LED display device applied in the embodiments will be abbreviated as simply the display device unless otherwise indicated. However, the embodiment is not limited to the micro LED display device, and other display devices listed above or known in the art may be applied to the extent that they share the technical ideas.

Furthermore, in the following drawings, the first direction DR1 refers to the horizontal direction of the display device 10, the second direction DR2 refers to the vertical direction of the display device 10, and the third direction DR3 refers to the thickness direction of the display device 10. In this case, "left", "right", "up", and "down" refers to directions when the display device 10 is viewed from a plane. For example, "right" refers to one side of the first direction DR1, "left" refers to the other side of the first directionDR1, "top" refers to one side of the second direction DR2, and "bottom" refers to the other side of the second direction DR2. Furthermore, "top" or "front" refers to one side of the third direction DR3, and "bottom" or "back" refers to the other side of the third direction DR3.

The display device 10 according to an embodiment may have a circular, oval, or square shape in plan view, for example, a square shape. Furthermore, when the display device 10 is a television, the display device 10 may have a rectangular shape with the long side located in the horizontal direction. However, embodiments of the present disclosure are not limited thereto, and the long side may be positioned in the vertical direction and may be installed to be rotatable such that the long side may be variably positioned in the horizontal or vertical direction.

The display device 10 may include a display area DPA and a non-display area NDA. The display area DPA may be an active area where an image is displayed. The display area DPA may have a square shape in a plan view similar to the overall shape of the display device 10, but is not limited thereto. In some embodiments, the display area DPA may have a circular or oval shape.

The display area DPA may include a plurality of pixels PX. The plurality of pixels PX may be arranged in a matrix direction. The shape of each pixel PX may be rectangular or square in plan view but is not limited thereto and may be a rhombic shape with each side inclined with respect to the direction of one side of the display device 10. The plurality of pixels PX may include multiple color pixels PX. For example, the plurality of pixels PX may include, but are not limited to, a red first color pixel PX, a green second color pixel PX, and a blue third color pixel PX. Each color pixel PX may be alternately arranged in a stripe type or a pentile type.

A non-display area NDA may be arranged around the display area DPA. The non-display area NDA may completely or partially surround the display area DPA. The display area DPA may have various shapes, such as, for example, circular or square. The non-display area NDA may be formed to surround the display area DPA. The non-display area NDA may be composed of a bezel of the display device 10.

A driving circuit or driving element that drives the display area DPA may be disposed in the non-display area NDA. In an embodiment, a pad portion is provided on the display substrate of the display device 10 in the non-display area NDA disposed adjacent to the first side (lower side in FIG. 1) of the display device 10, and an external device EXD may be mounted on the electrode of the pad portion. Examples of the external device EXD include a connection film, a printed circuit board, a driving chip DIC, a connector, a wiring connection film, and the like. A scan driving portion SDR formed directly on the display substrate of the display device 10 may be disposed in the non-display area NDA adjacent to the second side (left side in FIG. 1) of the display device 10.

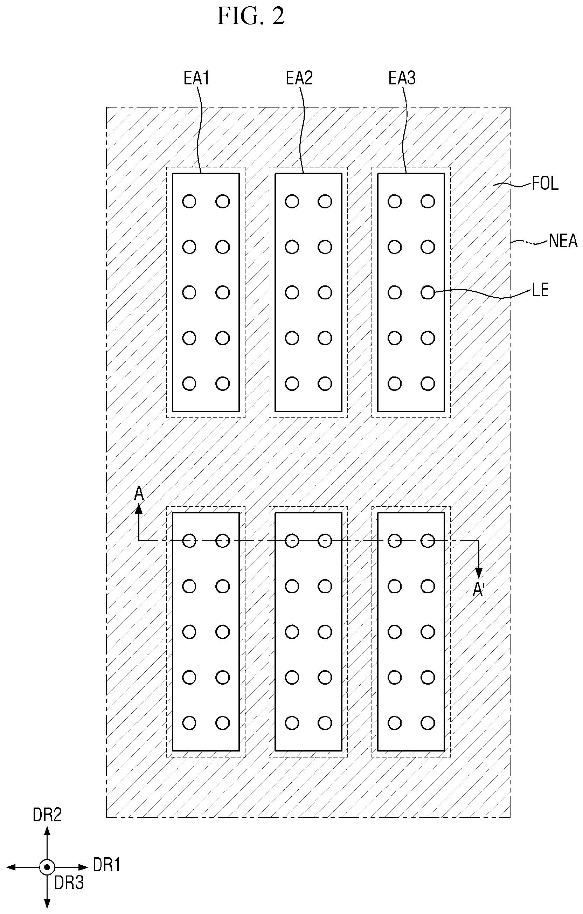

FIG. 2 is a plan view schematically illustrating the emission area of each pixel according to an embodiment.

Referring to FIG. 2, a plurality of pixels PX may be arranged in a matrix direction, and the plurality of pixels PX may be divided into a red first color pixel PX, a green second color pixel PX, and a blue third color pixel PX. In some aspects, a white fourth color pixel PX may be further included.

The pixel electrode of the first color pixel PX is located in the first emission area EA1, but at least part of the pixel electrode may extend to the non-emission area NEA. The pixel electrode of the second color pixel PX is located in the second emission area EA2, but at least part of the pixel electrode may extend to the non-emission area NEA. The pixel electrode of the third color pixel PX is located in the third emission area EA3, but at least part of the pixel electrode may extend to the non-emission area NEA. The pixel electrode of each pixel PX may be connected to one or more switching elements included in the respective pixel circuit penetrating at least one layer of insulating layer.

A plurality of light emitting elements LE are disposed on the pixel electrode of the first emission area EA1, the pixel electrode of the second emission area EA2, and the pixel electrode of the third emission area EA3. Here, each light emitting element LE may be formed of a micro LED. The light emitting elements LE are disposed in each of the first emission area EA1, the second emission area EA2, and the third emission area EA3. In some aspects, a red first color filter, a green second color filter, and a blue third color filter may be disposed on the first emission area EA1, the second emission area EA2, and the third emission area EA3, respectively, where the plurality of light emitting elements LE are disposed. A first organic layer FOL may be disposed in the non-emission area NEA.

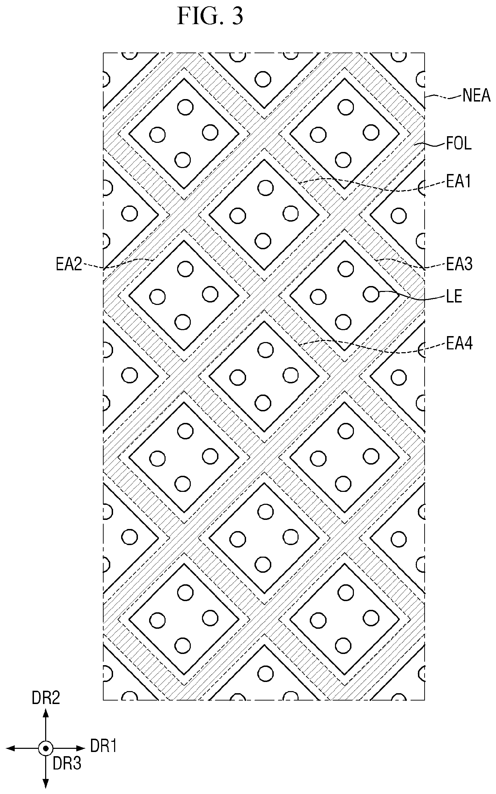

FIG. 3 is a plan view schematically illustrating the emission area of each pixel according to another embodiment.

Referring to FIG. 3, the shape of each pixel PX is not limited to a rectangular or square shape in plan view but may be a rhombus shape in which each side is inclined with respect to one side of the display device 10 to form a pentile structure. Accordingly, each pixel PX of the pen tile structure may be formed in a rhombus shape with a first emission area EA1 of the first color pixel PX, a second emission area EA2 of the second color pixel PX, a third emission area EA3 of the third color pixel PX, and a fourth emission area EA4 of any of the first to third colors of the color pixel PX.

The size or planar area of the first to fourth emission areas EA1 to EA4 of each pixel PX may be the same or different from each other. Similarly, the number of light emitting elements LE formed in the first to fourth emission areas EA1 to EA4 may be the same or different from each other.

The area of the first emission area EA1, the area of the second emission area EA2, the area of the third emission area EA3, and the area of the fourth emission area EA4 may be substantially the same but may be different from each other, without limitation. The distance between adjacent first and second emission areas EA1 and EA2 that are adjacent to each other, the distance between the second and third emission areas EA2 and EA3 that are adjacent to each other, the distance between the adjacent first and third emission areas EA1 and EA3 that are adjacent to each other, and the distance between the adjacent third and fourth emission areas EA3 and EA4 that are adjacent to each other may be substantially the same or may be different from each other. The embodiments of this disclosure are not limited thereto.

In some aspects, the first emission area EA1 may emit the first light, the second emission area EA2 may emit the second light, and the third emission area EA3 and the fourth emission area EA4 may emit the third light but embodiments of the present disclosure are not limited thereto. For example, the first emission area EA1 may emit the second light, the second emission area EA2 may emit the first light, and the third and fourth emission areas EA3 and EA4 may emit the third light. Alternatively, the first emission area EA1 may emit the third light, the second emission area EA2 may emit the second light, and the first and fourth emission areas EA3 and EA4 may emit the first light. Alternatively, at least one of the first to fourth emission areas EA1 to EA4 may emit a fourth light. The fourth light may be light in a yellow wavelength band. That is, the main peak wavelength of the fourth light may be located at approximately 550 nm to 600 nm, but the embodiments of the present disclosure are not limited thereto.

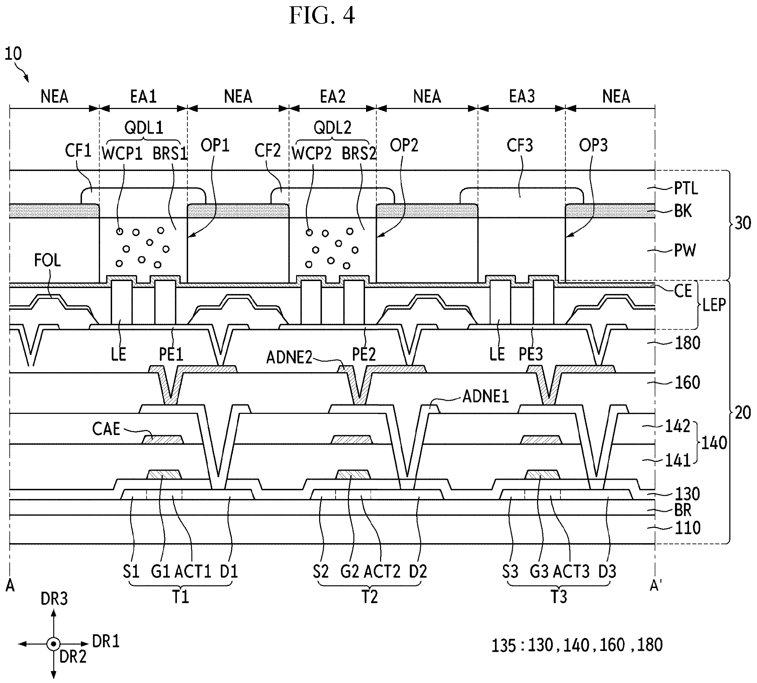

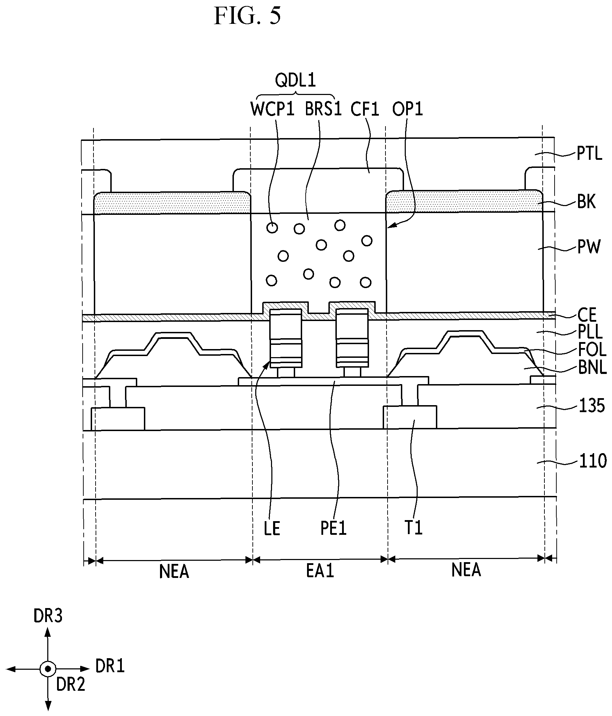

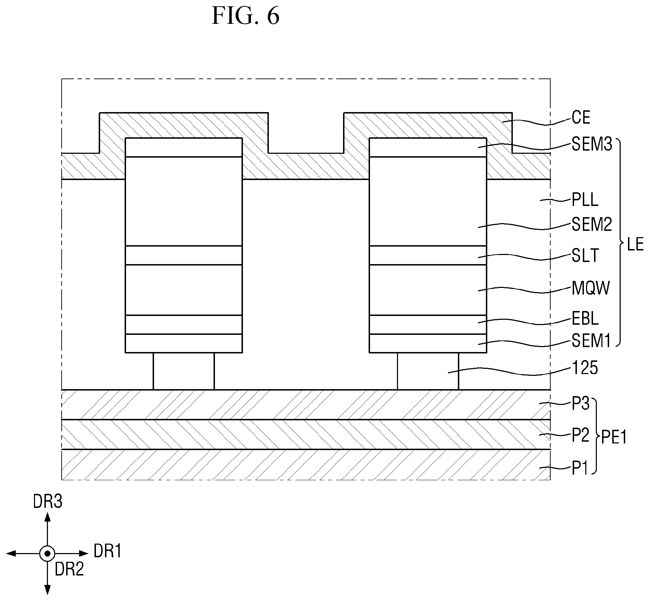

FIG. 4 is a cross-sectional view schematically illustrating the line A - A' of FIG. 2 according to an embodiment. FIG. 5 is an enlarged view schematically illustrating the first emission area of FIG. 4. FIG. 6 is a cross-sectional view illustrating the light emitting element of FIG. 5 in detail.

Referring to FIGS. 4 to 6, the display panel of the display device 10 may include a display substrate 20 and a wavelength conversion portion 30 disposed on the display substrate 20.

A barrier film BR may be disposed on the first substrate 110 of the display substrate 20. The first substrate 110 may be formed of an insulating material such as, for example, polymer resin. For example, the first substrate 110 may be formed of polyimide. The first substrate 110 may be a flexible substrate capable of bending, folding, rolling, and the like.

The barrier film BR is a film configured to protect the thin film transistors T1, T2, and T3 and the light emitting element LEP from moisture penetrating through the first substrate 110, which is vulnerable to moisture penetration. The barrier film BR may be composed of a plurality of inorganic films stacked alternately. For example, the barrier film BR may be formed as a multilayer of alternately stacked inorganic films of one or more of a silicon nitride layer, a silicon oxynitride layer, a silicon oxide layer, a titanium oxide layer, and an aluminum oxide layer.

Each transistor T1, T2, and T3 may be disposed on the barrier film BR. Each thin film transistor T1, T2, and T3 includes an active layer ACT1, a gate electrode G1, a source electrode S1, and a drain electrode D1.

The active layer ACT1, source electrode S1, and drain electrode D1 of the thin film transistors T1, T2, and T3 may be disposed on the barrier film BR. The active layer ACT1 of the thin film transistors T1, T2, and T3 may include polycrystalline silicon, monocrystalline silicon, low temperature polycrystalline silicon, amorphous silicon, or an oxide semiconductor. The active layer ACT1 overlapping the gate electrode G1 in the third direction (Z-axis direction), which is the thickness direction of the first substrate 110, may be defined as a channel region. The source electrode S1 and the drain electrode D1 are regions that do not overlap with the gate electrode G1 in the third direction (z-axis direction) and may have conductivity due to doping of ions or impurities in the silicon semiconductor or oxide semiconductor.

A gate insulating layer 130 may be disposed on the active layer ACT1, the source electrode S1, and the drain electrode D1 of the thin film transistors T1, T2, and T3. The gate insulating layer 130 may be formed of an inorganic film, such as, for example, a silicon nitride layer, a silicon oxynitride layer, a silicon oxide layer, a titanium oxide layer, or an aluminum oxide layer.

A gate electrodes G1 of thin film transistors T1, T2, and T3 may be disposed on the gate insulating layer 130. The gate electrode G1 may overlap the active layer ACT1 in the third direction (Z-axis direction). The gate electrode G1 may be formed of an inorganic film, such as, for example, a silicon nitride layer, a silicon oxynitride layer, a silicon oxide layer, a titanium oxide layer, or an aluminum oxide layer.

A first interlayer insulating film 141 may be disposed on the gate electrode G1 of the thin film transistors T1, T2, and T3. The first interlayer insulating film 141 may be formed of an inorganic film, such as, for example, a silicon nitride layer, a silicon oxynitride layer, a silicon oxide layer, a titanium oxide layer, or an aluminum oxide layer. The first interlayer insulating film 141 may be formed of a plurality of inorganic films.

A capacitor electrode CAE may be disposed on the first interlayer insulating film 141. The capacitor electrode CAE may overlap the gate electrode G1 of the thin film transistors T1, T2, and T3 in the third direction (Z-axis direction). Since the first interlayer insulating film 141 has a predetermined dielectric constant, a capacitor may be formed by the capacitor electrode CAE, the gate electrode G1, and the first interlayer insulating film 141 disposed between them. The capacitor electrode CAE may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second interlayer insulating film 142 may be disposed on the capacitor electrode CAE. The second interlayer insulating film 142 may be formed of an inorganic film, such as, for example, a silicon nitride layer, a silicon oxynitride layer, a silicon oxide layer, a titanium oxide layer, or an aluminum oxide layer. The second interlayer insulating film 142 may be formed of a plurality of inorganic films.

A first anode connection electrode ANDE1 may be disposed on the second interlayer insulating film 142. The first anode connection electrode ANDE1 may be connected to the drain electrode D1 of the thin film transistor ST1 through a first connection contact hole ANCT1 penetrating the gate insulating layer 130, the first interlayer insulating film 141, and the second interlayer insulating film 142. The first anode connection electrode ANDE1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first planarization film 160 may be disposed on the first anode connection electrode ANDE1 to flatten the steps caused by the thin film transistors T1, T2, and T3. The first planarization film 160 may be formed of an organic film such as, for example, an acrylic resin, an epoxy resin, a phenolic resin, a polyamide resin, a polyimide resin, or the like.

A second anode connection electrode ANDE2 may be disposed on the first planarization film 160. The second anode connection electrode ANDE2 may be connected to the first anode connection electrode ANDE1 through a second connection contact hole ANCT2 penetrating the first planarization film 160. The second anode connection electrode ANDE2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second planarization film 180 may be disposed on the second anode connection electrode ANDE2. The second planarization film 180 may be formed of an organic film such as, for example, an acrylic resin, an epoxy resin, a phenolic resin, a polyamide resin, a polyimide resin, or the like.

A light emitting element portion LEP may be formed on the second planarization film 180. The light emitting element portion LEP may include a plurality of pixel electrodes PE1, PE2, and PE3, a plurality of light emitting elements LE, and a common electrode CE.

The plurality of pixel electrodes PE1, PE2, and PE3 may include a first pixel electrode PE1, a second pixel electrode PE2, and a third pixel electrode PE3. The first pixel electrode PE1, the second pixel electrode PE2, and the third pixel electrode PE3 may serve as the first electrode of the light emitting element LE and may be an anode electrode or a cathode electrode. The first pixel electrode PE1 may be located in the first emission area EA1 but may extend at least partially into the non-emission area NEA. The second pixel electrode PE2 may be located in the second emission area EA2 but may extend at least partially into the non-emission area NEA. The third pixel electrode PE3 is located in the third emission area EA3 but may extend at least partially into the non-emission area NEA. The first pixel electrode PE1 may be connected to a first switching element T1 by penetrating the gate insulating layer 130, the second pixel electrode PE2 may be connected to a second switching element T2 by penetrating the gate insulating layer 130, and the third pixel electrode PE3 may be connected to the third switching element T3 by penetrating the gate insulating layer 130.

The first pixel electrode PE1, the second pixel electrode PE2, and the third pixel electrode PE3 may be reflective electrodes. The first pixel electrode PE1, the second pixel electrode PE2, and the third pixel electrode PE3 may be formed of titanium (Ti) or copper (Cu) or an alloy material of titanium (Ti) and copper (Cu). In some aspects, first pixel electrode PE1, the second pixel electrode PE2, and the third pixel electrode PE3 may each have a laminated film structure of Ti (Titanium) and Copper (Cu). Further, the first pixel electrode PE1, the second pixel electrode PE2, and the third pixel electrode PE3 may be formed from a material layer having a high work function of titanium oxide (TiO₂), indium tin oxide (ITO), indium zinc oxide (IZO), zinc oxide (ZnO), indium tin zinc oxide (ITZO), or magnesium oxide (MgO) and silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), titanium (Ti), copper (Cu), or mixtures thereof, or the like. A material layer with a high work function may be disposed above the reflective material layer and may be disposed close to the light emitting element LE. The first pixel electrode PE1, the second pixel electrode PE2, and the third pixel electrode PE3 may have a multilayer structure of ITO/Mg, ITO/MgF, ITO/Ag, ITO/Ag/ITO, but are not limited thereto.

A bank BNL may be located on the first pixel electrode PE1, the second pixel electrode PE2, and the third pixel electrode PE3. The bank BNL may include an opening exposing the first pixel electrode PE1, an opening exposing the second pixel electrode PE2, and an opening exposing the third pixel electrode PE3, and may define an emission area EA1, a second emission EA2, a third emission EA3, and a non-emission area NEA. In other words, the area of the first pixel electrode PE1 that is not covered by the bank BNL and is exposed may be the first emission area EA1. The area of the second pixel electrode PE2 that is not covered by the bank BNL and is exposed may be the second emission area EA2. The area of the third pixel electrode PE3 that is not covered by the bank BNL and is exposed may be the third emission area EA3. In some aspects, the area where the bank BNL is located may be the non-emission area NEA.

The bank BNL may include an organic insulating material, for example, a polyacrylates resin, an epoxy resin, a phenolic resin, a polyamides resin, a polyimides rein, unsaturated polyesters resin, poly phenylenethers resin, polyphenylenesulfides resin, or benzocyclobutene (BCB).

In an embodiment, the bank BNL may overlap with the color filters CF1, CF2, and CF3 and the light blocking member BK of the wavelength converter 30, which will be described later. In an embodiment, the bank BNL may completely overlap light blocking member BK. In some aspects, the bank BNL may overlap the first color filter CF1, the second color filter CF2, and the third color filter CF3.

A plurality of light emitting elements LE may be disposed on the first pixel electrode PE1, the second pixel electrode PE2, and the third pixel electrode PE3.

As illustrated in FIGS. 5 and 6, the light emitting element LE may be disposed in each of the first emission area EA1, the second emission area EA2, and the third emission area EA3. The light emitting element LE may be a vertical light emitting diode element extending long in the third direction DR3. That is, the length of the light emitting element LE in the third direction DR3 may be longer than the length in the horizontal direction. The length in the horizontal direction refers to the length in the first direction DR1 or the length in the second direction DR2. For example, the length of the light emitting element LE in the third direction DR3 may be approximately 1 to 5 µm.

Each light emitting element LE may be a micro light emitting diode (micro LED). The light emitting element LE may be connected to a connection electrode 125, a first semiconductor layer SEM1, an electron blocking layer EBL, an active layer MQW, a superlattice layer SLT, a second semiconductor layer SEM2, and a third semiconductor layer SEM3 in the thickness direction of the display substrate 20, i.e., the third direction DR3. The connection electrode 125, the first semiconductor layer SEM1, the electron blocking layer EBL, the active layer MQW, the superlattice layer SLT, the second semiconductor layer SEM2, and the third semiconductor layer SEM3 may be stacked sequentially in the third direction DR3.

The light emitting element LE may have a cylindrical shape, a disk shape, a bridge shape, or a rod shape where the width is longer than the height. However, embodiments of the present disclosure are not limited thereto, and the light emitting element LE may have a shape such as, for example, a rod, wire, tube, and the like, a polygonal shape such as, for example, a cube, rectangular cube, hexagonal column, and the like, or a shape that extends in one direction but has a partially sloped outer surface.

The connection electrode 125 may be disposed on top of each of the plurality of pixel electrodes PE1, PE2, and PE3. In the following, the light emitting element LE disposed on the first pixel electrode PE1 will be described as an example.

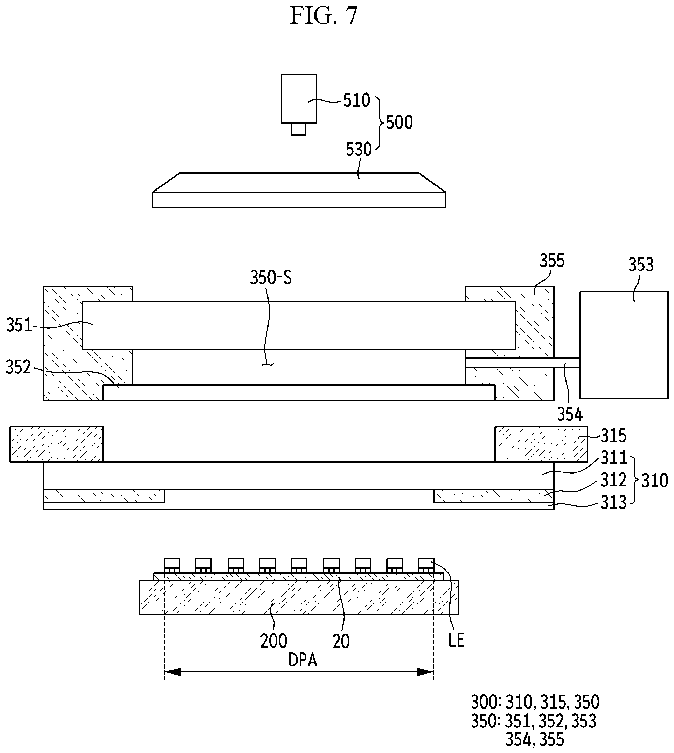

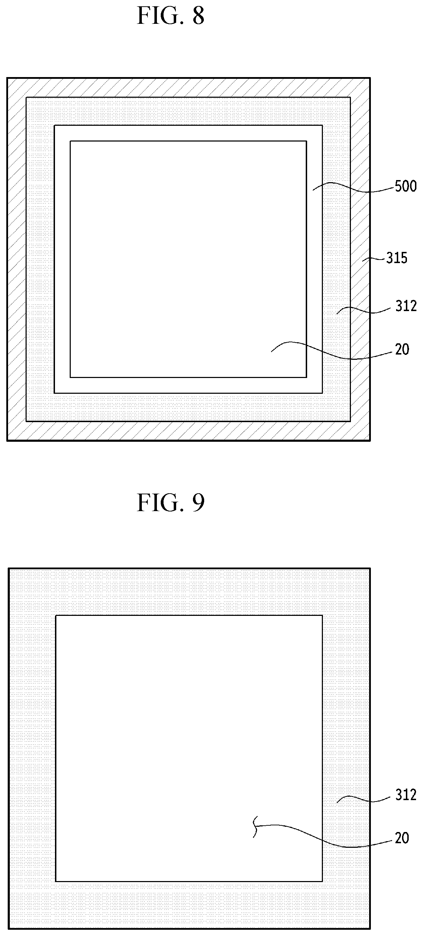

The connection electrode 125 may bond with the first pixel electrode PE1 and serve to apply an emission signal to the light emitting element LE. The connection electrode 125 may be an ohmic connection electrode. However, the electrode is not limited to this and may be a Schottky connection electrode. The light emitting element LE may include at least one connection electrode 125. FIG. 7 and 8 illustrate that the light emitting element LE includes one connection electrode 125, but embodiments of the present disclosure are not limited thereto. In some cases, the light emitting element LE may include a greater number of connection electrodes 125 or may be omitted. The description of the light emitting element LE described later may be applied equally even for cases in which the number of connection electrodes 125 is different or a different structure is added.

The connection electrode 125 may reduce resistance and improve adhesion between the light emitting element LE and the first pixel electrode PE1 when the light emitting element LE is electrically connected to the first pixel electrode PE1 in the display device 10 according to an embodiment. The connection electrode 125 may include a conductive metal oxide. For example, the connection electrode 125 may be ITO. Since the connection electrode 125 is connected by direct contact with the lower first pixel electrode PE1, the connection electrode 125 may be formed of the same material as the first pixel electrode PE1. Further, the connection electrode 125 may optionally further include a reflective electrode formed of a highly reflective metal material such as, for example, aluminum (Al) or an anti-diffusion layer including nickel (Ni). Accordingly, the adhesion between the connection electrode 125 and the first pixel electrode PE1 may be improved, thereby increasing the contact characteristics.

Referring to FIG. 6, In an embodiment, the first pixel electrode PE1 may include a lower electrode layer P1, a reflective layer P2, and an upper electrode layer P3. The lower electrode layer P1 may be disposed at the bottom of the first pixel electrode PE1 and may be electrically connected to the switching element. The lower electrode layer P1 may include a metal oxide, for example, titanium oxide (TiO₂), indium tin oxide (ITO), indium zinc oxide (IZO), zinc oxide (ZnO), indium tin zinc oxide (ITZO), or magnesium oxide (MgO).

The reflective layer P2 may be disposed on the lower electrode layer P1 to reflect light emitted from the light emitting element LE to the upper electrode layer. The reflective layer P2 may include a highly reflective metal, for example, silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), or a mixture thereof.

The upper electrode layer P3 is disposed on the reflective layer P2 and may be in direct contact with the light emitting element LE. The upper electrode layer P3 may be disposed between the reflective layer P2 and the connection electrode 125 of the light emitting element LE and may be in direct contact with the connection electrode 125. As described herein, the connection electrode 125 is formed of metal oxide, and the upper electrode layer P3 may also be formed of metal oxide in the same way as the connection electrode 125.

The upper electrode layer P3 may be formed of titanium (Ti) or copper (Cu) or an alloy material of titanium (Ti) and copper (Cu). In some aspects, the upper electrode layer P3 may have a laminated film structure of Ti (Titanium) and Copper (Cu). Further, the upper electrode layer P3 may include titanium oxide (TiO₂), indium tin oxide (ITO), indium zinc oxide (IZO), zinc oxide (ZnO), indium tin zinc oxide (ITZO), or magnesium oxide (MgO). In an embodiment, when the connection electrode 125 is formed of ITO, the first pixel electrode PE1 may be formed of a multilayer structure of ITO/Ag/ITO.

The first semiconductor layer SEM1 may be disposed on the connection electrode 125. The first semiconductor layer SEM1 may be a p-type semiconductor and may include a semiconductor material having a chemical formula of AlxGayIn1-x-yN(0≤x≤1,0≤y≤1, 0≤x+y≤1). For example, the first semiconductor layer SEM1 may be any one or more of p-type doped AlGaInN, GaN, AlGaN, InGaN, AIN, and InN. The first semiconductor layer SEM1 may be doped with a p-type dopant, and the p-type dopant may be Mg, Zn, Ca, Se, Ba, or the like. For example, the first semiconductor layer SEM1 may be p-GaN doped with p-type Mg. The thickness of the first semiconductor layer SEM1 may range from 30 nm to 200 nm but is not limited thereto.

The electron blocking layer EBL may be disposed on the first semiconductor layer SEM1. The electron blocking layer EBL may be a layer to suppress or prevent too many electrons from flowing into the active layer MQW. For example, the electron blocking layer EBL may be p-AlGaN doped with p-type Mg. The thickness of the electron blocking layer EBL may range from 10 nm to 50 nm but is not limited thereto. In some aspects, the electron blocking layer EBL may be omitted.

The active layer MQW may be disposed on the electron blocking layer EBL. The active layer MQW may emit light by combining electron-hole pairs according to an electrical signal applied through the first semiconductor layer SEM1 and the second semiconductor layer SEM2.

The active layer MQW may include a single or multiple quantum well structure. In an example in which the active layer includes a material with a multi-quantum well structure, the active layer may be a stacked structure with a plurality of well layers and a barrier layer alternating with each other. In this case, the well layer may be formed of InGaN and the barrier layer may be formed of GaN or AlGaN, but is not limited thereto. The thickness of the well layer may be approximately 1 to 4 nm, and the thickness of the barrier layer may be 3 nm to 10 nm.

Alternatively, the active layer MQW may have a structure in which a semiconductor material having a large band gap energy and a semiconductor material having a small band gap energy are alternately stacked with each other and may include other Group 3 to Group 5 semiconductor materials depending on the wavelength band of the emitted light. The light emitted from the active layer MQW is not limited to the first light and may emit second light (light of a green wavelength band) or third light (light of a red wavelength band) according to circumstances.

Specifically, the color of light emitted from the active layer MQW may vary depending on the indium (In) content. For example, as the content of indium (In) decreases, the wavelength band of light emitted by the active layer may shift to a red wavelength band, and as the content of indium (In) increases, the wavelength band of light emitted may shift to a blue wavelength band. In one example, for a case in which the indium (In) content is within 15%, the active layer MQW may emit first light in a red wavelength band with a main peak wavelength ranging from approximately 600 nm to 750 nm. In contrast, in one example, for a case in which the indium (In) content is set to 25%, the active layer MQW may emit second light in a green wavelength band with a main peak wavelength ranging from approximately 480 nm to 560 nm. Furthermore, when the indium (In) content is 35% or more, the active layer MQW may emit third light in a blue wavelength band with a main peak wavelength ranging from approximately 370 nm to 460 nm. Through FIG. 6, an example in which the active layer MQW emits light in a blue wavelength band with a main peak wavelength ranging from approximately 370 nm to 460 nm will be described.

The superlattice layer SLT may be disposed on the active layer MQW. The superlattice layer SLT may be a layer for relieving stress between the second semiconductor layer SEM2 and the active layer MQW. For example, the superlattice layer SLT may be formed of InGaN or GaN. The thickness of the superlattice layer SLT may be approximately 50 to 200 nm. The superlattice layer SLT may be omitted.

The second semiconductor layer SEM2 may be disposed on the superlattice layer SLT. The second semiconductor layer SEM2 may be an n-type semiconductor. The second semiconductor layer SEM2 may include a semiconductor material having the chemical formula AlxGayIn1-x-yN(0≤x≤1,0≤y≤1, 0≤x+y≤1). For example, the second semiconductor layer SEM2 may be one or more of n-type doped AlGaInN, GaN, AlGaN, InGaN, AIN, and InN. The second semiconductor layer SEM2 may be doped with an n-type dopant, and the n-type dopant may be Si, Ge, Sn, or the like. For example, the second semiconductor layer SEM2 may be n-GaN doped with n-type Si. The thickness of the second semiconductor layer SEM2 may range from 2 *µ*m to 4 *µ*m but is not limited thereto.

The third semiconductor layer SEM3 may be disposed on the second semiconductor layer SEM2. The third semiconductor layer SEM3 may be disposed between the second semiconductor layer SEM2 and the common electrode CE. The third semiconductor layer SEM3 may be an undoped semiconductor. The third semiconductor layer SEM3 may include the same material as the second semiconductor SEM2 but may be a material undoped with an n-type or p-type dopant. In an embodiment, the third semiconductor layer SEM3 may be at least one of undoped InAlGaN, GaN, AlGaN, InGaN, AIN, and InN but is not limited thereto.

A planarization layer PLL may be disposed on the bank BNL and the plurality of pixel electrodes PE1, PE2, and PE3. The planarization layer PLL may flatten a lower step such that a common electrode CE, which will be described later, may be formed. The planarization layer PLL may be formed at a predetermined height such that at least a portion of the plurality of light emitting elements LE, for example, an upper portion, may protrude above the planarization layer PLL. In other words, the height of the planarization layer PLL relative to the top surface of the first pixel electrode PE1 may be less than the height of the light emitting element LE.

The planarization layer PLL may include an organic material to flatten the lower step. For example, the planarization layer PLL may include a polyacrylates resin, an epoxy resin, a phenolic resin, a polyamides resin, a polyimides rein, an unsaturated polyesters resin, a polyphenylene resin, or a polyester resin, unsaturated polyesters resin, poly phenylenethers resin, polyphenylenesulfides resin, or benzocyclobutene (BCB).

A common electrode CE may be disposed on the planarization layer PLL and the plurality of light emitting elements LE. Specifically, the common electrode CE may be disposed on one surface of the first substrate 110 on which the light emitting element LE is formed and may be disposed throughout the display area DA and the non-display area NDA. The common electrode CE is disposed to overlap each of the emission areas EA1, EA2, and EA3 in the display area DA, and may be thin such that light may be emitted.

The common electrode CE may be directly disposed on the top and side surfaces of the plurality of light emitting elements LE. The common electrode CE may directly contact the second semiconductor layer SEM2 and the third semiconductor layer SEM3 on the side of the light emitting element LE. As illustrated in FIG. 6, the common electrode CE covers the plurality of light emitting elements LE and may be a common layer arranged to commonly connect the plurality of light emitting elements LE. Since the conductive second semiconductor layer SEM2 has a structure in which each light emitting element LE is patterned, the common electrode CE may directly contact a side of the second semiconductor layer SEM2 of each light emitting element LE such that a common voltage may be applied to each light emitting element LE.

Since the common electrode CE is disposed entirely on the first substrate 110 and applies a common voltage, the common electrode CE may include a material with low resistance. Further, the common electrode CE may be formed to be thin to facilitate light transmission. For example, the common electrode CE may include a material having a low resistance, such as, for example, aluminum (Al), silver (Ag), copper (Cu), or the like. The thickness of the common electrode CE may be approximately 10Å to 200Å but is not limited thereto.

The described light emitting elements LE may receive a pixel voltage or anode voltage from the pixel electrode through the connection electrode 125 and may receive a common voltage through the common electrode CE. The light emitting element LE may emit light with a predetermined brightness depending on the voltage difference between the pixel voltage and the common voltage.

In this embodiment, by disposing a plurality of light emitting elements LE, that is, inorganic light emitting diodes, on the pixel electrodes PE1, PE2, and PE3, the disadvantages of organic light emitting diodes, which are vulnerable to external moisture or oxygen, may be eliminated and the lifespan and reliability may be improved.

In some embodiments, a first organic layer FOL may be disposed on the bank BNL disposed in the non-emission area NEA.

The first organic layer FOL overlaps the non-emission area NEA and may be disposed to non-overlap with the emission areas EA1, EA2, and EA3. The first organic layer FOL is directly disposed on the bank BNL and may be disposed to be spaced apart from a plurality of adjacent pixel electrodes PE1, PE2, and PE3. The first organic layer FOL may be disposed entirely on the first substrate 110, surrounding the plurality of emission areas EA1, EA2, and EA3. The first organic layer FOL may be disposed overall in a lattice shape.

The first organic layer FOL may serve to detach the plurality of light emitting elements LE that are in contact with the first organic layer FOL, which is the non-emission area NEA, as will be explained in the manufacturing process described later. In an example in which the first organic layer FOL is irradiated with laser light, the first organic layer FOL absorbs energy and the temperature of the first organic layer FOL instantly increases, resulting in ablation. Accordingly, the plurality of light emitting elements LE in contact with the top surface of the first organic layer FOL may be detached from the top surface of the first organic layer FOL.

The first organic layer FOL may include a polyimide-based compound. The polyimide-based compound of the first organic layer FOL may include a cyano group to absorb light with a wavelength of 308 nm, for example, laser light. In an embodiment, the first organic layer FOL and the bank BNL each include a polyimide-based compound but may include different polyimide-based compounds. For example, the bank BNL may be formed of a polyimide-based compound that does not contain a cyano group, and the first organic layer FOL may be formed of a polyimide-based compound that includes a cyano group. For laser light with a wavelength of 308 nm, the transmittance of the first organic layer FOL may be less than the transmittance of the bank BNL, such that the transmittance of the bank BNL may be about 60% or more and the transmittance of the first organic layer FOL may be 0%. Further, the absorption rate of the first organic layer FOL for laser light with a wavelength of 308 nm may be 100%. The first organic layer FOL may have a thickness ranging from about 2Å to 10 *µ*m. In an example in which the thickness of the first organic layer FOL is 2 Å or more, the absorption rate of laser light with a wavelength of 308 nm may be improved. In an example in which the thickness of the first organic layer FOL is 10 *µ*m or less, a step between the first organic layer FOL and the pixel electrode PE1 may be prevented from increasing, thereby facilitating the bonding of the light emitting element LE on the pixel electrode in the process described later.

The wavelength conversion portion 30 may be disposed on the light emitting element portion LEP. The wavelength converter 30 may include a partition wall PW, a wavelength conversion layer QDL, color filters CF1, CF2, and CF3, a light blocking member BK, and a protective layer PTL.

The partition wall PW is disposed on the common electrode CE of the display area DPA and, together with the bank BNL, may compartmentalize a plurality of emission areas EA1, EA2, and EA2. The partition wall PW is arranged to extend in the first direction DR1 and the second direction DR2 and may be formed in a grid-like pattern throughout the display area DA. Furthermore, the partition wall PW may not overlap with the plurality of emission areas EA1, EA2, and EA3 and may overlap with the non-emission area NEA.

The partition wall PW may include a plurality of openings OP1, OP2, and OP3 exposing the lower common electrode CE. The plurality of openings OP1, OP2, and OP3 may include a first opening OP1 overlapping the first emission area EA1, a second opening OP2 overlapping the second emission area EA2, and a third opening OP3 overlapping the third emission area EA3. Here, the plurality of openings OP1, OP2, and OP3 may correspond to the plurality of emission areas EA1, EA2, and EA3. That is, the first opening OP1 corresponds to the first emission area EA1, the second opening OP2 corresponds to the second emission area EA2, and the third opening OP3 corresponds to the third emission area EA3.

The partition wall PW may serve to provide a space for forming the first and second wavelength conversion layers QDL1 and QDL2. To this end, the partition wall PW may be formed of a predetermined thickness. For example, the thickness of the partition wall PW may be in the range of 1 *µ*m to 10 *µ*m. The partition wall PW may include an organic insulating material to have a predetermined thickness. The organic insulating material may include, for example, an epoxy-based resin, an acrylic-based resin, a cardo-based resin, or an imide-based resin.

The first wavelength conversion layer QDL1 may be disposed within each of the first openings OP1. The first wavelength conversion layer QDL1 may be formed in a dot-shaped island pattern spaced apart from each other. The first wavelength conversion layer QDL1 may include a first base resin BRS1 and a first wavelength conversion particles WCP1. The first base resin BRS1 may include a light-transmitting organic material. For example, the first base resin BRS1 may include an epoxy-based resin, an acrylic-based resin, a cardo-based resin, or an imide-based resin. The first wavelength conversion particle WCP1 may be a quantum dot (QD), a quantum rod, a fluorescent material, or a phosphorescent material. For example, quantum dots may be particulate materials that emit a specific color as electrons transition from the conduction band to the valence band.

The quantum dot may be a semiconductor nanocrystal material. The quantum dots have a specific bandgap depending on their composition and size and may absorb light and then emit light with a unique wavelength. Examples of the semiconductor nanocrystals of the quantum dots include group IV nanocrystals, group II-VI compound nanocrystals, group III-V compound nanocrystals, group IV-VI nanocrystals, or combinations thereof.

The first wavelength conversion layer QDL1 may be formed in the first opening OP1 of the first emission area EA1. The first wavelength conversion layer QDL1 may convert or shift the peak wavelength of incident light into light of another specific peak wavelength and emit it. The first wavelength conversion layer QDL1 may convert a portion of the blue light emitted from the light emitting element LE into light similar to red, which is the first light. The first wavelength conversion layer QDL1 emits light similar to red such that may be converted into red light, which is the first light, through the first color filter CF1.

The second wavelength conversion layer QDL2 may be disposed within each of the second openings OP2. The second wavelength conversion layer QDL2 may be formed in a dot-shaped island pattern spaced apart from each other. For example, the second wavelength conversion layer QDL2 may be disposed to overlap the second emission area EA2. The second wavelength conversion layer QDL2 may include a second base resin BRS2 and second wavelength conversion particles WCP2. The second base resin BRS2 may include a light-transmitting organic material. Accordingly, the second wavelength conversion layer QDL2 may convert or shift the peak wavelength of the incident light into light of another specific peak wavelength and emit it. The second wavelength conversion layer QDL2 may convert a portion of the blue light emitted from the light emitting element LE into light similar to green light, which is the second light. The second wavelength conversion layer QDL2 emits light similar to green and may be converted into red light, which is the first light, through the second color filter CF2.

In the third emission area EA3, a transparent, light-transmitting organic material is formed in the third opening OP3, such that the blue light emitted from the light emitting element LE may be emitted as-is through the third color filter CF3.

A plurality of color filters CF1, CF2, and CF3 may be disposed on the partition wall PW and the first and second wavelength conversion layers QDL1 and QDL2. The plurality of color filters CF1, CF2, and CF3 may be arranged to overlap the plurality of openings OP1, OP2, and OP3 and the first and second wavelength conversion layers QDL1 and QDL2. The plurality of color filters CF1, CF2, and CF3 may include a first color filter CF1, a second color filter CF2, and a third color filter CF3.

The first color filter CF1 may be disposed to overlap the first emission area EA1. Further, the first color filter CF1 may be disposed on the first opening OP1 of the partition wall PW, overlapping with the first opening OP1. The first color filter CF1 may transmit the first light emitted from the light emitting element LE and absorb or block the second light and the third light. For example, the first color filter CF1 may transmit light in a blue wavelength band and absorb or block light in other wavelength bands such as, for example, green and red.

The second color filter CF2 may be disposed to overlap the second emission area EA2. Further, the second color filter CF2 may be disposed on the second opening OP2 of the partition wall PW, overlapping with the second opening OP2. The second color filter CF2 may transmit the second light and absorb or block the first light and the third light. For example, the second color filter CF2 may transmit light in a green wavelength band and absorb or block light in other wavelength bands such as, for example, blue and red.

The third color filter CF3 may be arranged to overlap the third emission area EA3. Further, the third color filter CF3 may be disposed on the third opening OP3 of the partition wall PW, overlapping with the third opening OP3. The third color filter CF3 may transmit third light and absorb or block first light and second light. For example, the third color filter CF3 may transmit light in a red wavelength band and absorb or block light in other wavelength bands such as, for example, blue and green.

The planar area of each of the plurality of color filters CF1, CF2, and CF3 may be larger than the planar area of each of the plurality of emission areas EA1, EA2, and EA3. For example, the first color filter CF1 may be larger than the planar area of the first emission area EA1. The second color filter CF2 may be larger than the planar area of the second emission area EA2. The third color filter CF3 may be larger than the planar area of the third emission area EA3. However, the present disclosure is not limited to this, and the planar area of each of the plurality of color filters CF1, CF2, and CF3 may be equal to the planar area of each of the plurality of emission areas EA1, EA2, and EA3.

Referring to FIG. 5, a light blocking member BK may be disposed on the partition wall PW. The light blocking member BK may block the transmission of light by overlapping the non-emission area NEA. The light blocking member BK may be arranged in a substantially grid-like arrangement on a plane, similar to the bank BNL or partition wall PW. The light blocking member BK may be disposed to overlap the bank BNL, the first organic layer FOL, and the partition wall PW, and may not overlap the emission areas EA1, EA2, and EA3.

In an embodiment, the light blocking member BK may include an organic light blocking material and may be formed through a coating and exposure process of the organic light blocking material. The light blocking member BK may include a dye or pigment having light blocking properties and may be a black matrix. At least a portion of the light blocking member BK may overlap with adjacent color filters CF1, CF2, and CF3, and the color filters CF1, CF2, and CF3 may be disposed on at least a portion of the light blocking member BK.

A protective layer PTL may be disposed on the plurality of color filters CF1, CF2, and CF3 and the light blocking member BK. The first protective layer PTL may be disposed at the top of the display device 10 and may protect the plurality of color filters CF1, CF2, and CF3 and the light blocking member BK below. One surface, for example, a bottom surface, of the protective layer PTL may contact the plurality of color filters CF1, CF2, and CF3 and the upper surface of the light blocking member BK, respectively.

The protective layer PTL may include an inorganic insulating material configured to protect the plurality of color filters CF1, CF2, and CF3 and the light blocking member BK. For example, the first protective layer PTL may include silicon oxide (SiOx), silicon nitride (SiNx), silicon oxynitride (SiOxNy), aluminum oxide (AlxOy), aluminum nitride (AIN), and the like but is not limited to. The first protective layer PTF1 may have a predetermined thickness, for example, in the range of 0.01 to 1 *µ*m. However, embodiments of the present disclosure are not limited thereto.

Hereinafter, a manufacturing device for a display panel that applies a pressure to and attaches a plurality of light emitting elements LE, namely micro LED, disposed on the pixel electrodes PE1, PE2, and PE3 of the display substrate 20 will be described in detail.

FIG. 7 is a side cross-sectional view schematically illustrating a manufacturing device for a display panel according to an embodiment. FIG. 8 is a front view schematically illustrating a top surface of the manufacturing device illustrated in FIG. 7.

Referring to FIGS. 7 and 8, the manufacturing device for the display panel may bond two or more bonding objects to each other using a laser beam. The bonding objects may be a substrate, a film, a display panel, a touch panel, or a semiconductor element such as, for example, a printed circuit board, a flexible circuit board, or a light emitting element. Hereinafter, an example in which a first bonding object is the display substrate 20 and a second bonding object is the light emitting element LE will be described.

The device for manufacturing a display panel may include a support portion 200, a pressing portion 300, and a laser irradiation portion 500.

The support portion 200 has a top surface parallel to a plane defined by a first direction DR1 and a second direction DR2 perpendicular to each other, and a display substrate 20 having the plurality of light emitting elements LE arranged on the top surface is mounted.

The support portion 200 may be a loading plate and may be formed in a polygonal flat plate shape such as, for example, a square or rectangular shape. In some aspects, the support portion 200 may be formed in a circular, oval, or other planar plate shape. Hereinafter, an example in which the support portion 200 is formed in the shape of a square flat plate shape will be described. In an embodiment, the support portion 200 may fix the display substrate 20.

The laser irradiation portion 500 is disposed on the front of the support portion 200, which will be described later, and emits laser light, irradiating the display substrate 20 with the laser light through the support portion 200. The laser irradiation portion 500 may be disposed on the uppermost surface of the manufacturing device. The laser irradiation portion 500 emits and radiates laser light in the direction of the support portion 200 on the lower surface, and the light emitted and radiated from the laser irradiation portion 500 is applied to the plurality of light emitting elements LE arranged on the display substrate 20.

The laser irradiation portion 500 may include a laser light source 510 and an optical system 530.

The laser light source 510 is a device capable of generating laser light by externally supplied energy and may be configured to generate laser light, such as, for example, a solid-state laser, such as, for example, a YAG laser, ruby laser, glass laser, YVO4 laser, LD laser, fiber laser, liquid laser, such as, for example, a pigment laser, CO₂ laser, excimer laser (ArF laser, KrF laser, XeCl laser, XeF laser, and the like), gaseous laser, such as, for example, an Ar laser, He-Ne laser, semiconductor laser, free-electron laser, and the like.

The optical system 530 may include a plurality of lenses. The optical system 530 may receive beam-shaped laser light from the laser light source 510 and perform optical dispersion to enable area heating for a predetermined area.

The laser light emitted from the optical system 530 may irradiate the light emitting elements LE arranged on the display substrate 20 mounted on the support portion 200 and may heat a predetermined area of the light emitting elements LE.

The pressing portion 300 may be spaced apart from the support portion 200 in the third direction DR3 and may be disposed on the front of the support portion 200. The pressing portion 300 may press the display substrate 20 and the light emitting element LE on the support portion 200.

The pressing portion 300 may include a photomask 310, a mounting member 315, and a pressing member 350.

The photomask 310 may be formed of a plurality of layers. The photomask 310 may include a base layer 311 and a light blocking pattern layer 312. In some aspects, the photomask 310 may further include a protective layer 313 on the light blocking pattern layer 312, but the protective layer 313 may be omitted.

The base layer 311 is formed in the form of a transparent or translucent flat plate, including at least one transparent material such as, for example, glass, quartz, silicon, or the like. The base layer 311 allows laser light to travel to the front or back side in the opposite direction. The base layer 311 is configured to transmit laser light incident the front side of the base layer 311 to the back side of the base layer 311. The base layer 311 is configured to transmit laser light incident the back side of the base layer 311 to the front side of the base layer 311.

The light blocking pattern layer 312 is disposed on one side of the base layer 311 and includes a pattern having light blocking or reflective properties. The thickness of the light blocking pattern layer 312 is not particularly limited but may have a film thickness within the range of 80 nm to 180 nm. Because if the light blocking pattern layer 312 is too thin, it becomes difficult to obtain desired light blocking properties or reflectivity, and if the light blocking pattern layer 312 is too thick, it becomes difficult to process the light blocking pattern with high precision.

The light blocking pattern layer 312 may be any material having light blocking properties, but is not particularly limited to, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. In an embodiment, chromium (Cr) is selected for the light blocking pattern layer 312.

The light blocking pattern layer 312 includes one opening. The laser beam may penetrate the opening. Accordingly, the opening may define a transmission area for the laser beam. Here, the light emitted and radiated from the laser irradiation portion 500 passes through one opening corresponding to the display area DPA of the display substrate 20 by the light blocking pattern layer 312 and is applied to the plurality of light emitting elements LE arranged on the display substrate 20.

The light blocking pattern layer 312 may be arranged such that the light blocking pattern layer 312 faces the light emitting element LE.

The protective layer 313 is disposed on the base layer 311 on which the light blocking pattern layer 312 is provided, and the protective layer 313 may protect the surface of the light blocking pattern layer 312 and prevent damage to the light blocking pattern. The thickness of the protective layer 313 is not particularly limited but may have a thickness within the range of approximately 2 to 3 µm. The protective layer 313 may be a transparent or translucent material, such as, for example, a transparent resin, including a transparent material.

The mounting member 315 may be attached to the outer rear surface of the photomask 310. For example, the mounting member 315 may be attached to the outer rear surface of the base layer 311. The mounting member 315 may be, for example, any one of an electrostatic chuck, an adhesive chuck, a vacuum chuck, and a porous vacuum chuck. In some aspects, the mounting member 315 may be a clamp but is not limited thereto. The mounting member 315 does not overlap the path of the laser light.

The pressing member 350 may include a light transmitting plate 351, an elastic body 352, a gas pressure regulator 353, a gas conduit 354, and a holding frame 355.

The light transmitting plate 351 and the elastic body 352 may be mounted on the holding frame 355 to overlap in the thickness direction. Accordingly, when the holding frame 355 is moved downward, the light transmitting plate 351 and the elastic body 352 mounted on the holding frame 355 may also be moved downwardly, pressing down on the photomask 310 located beneath them.

A closed space 350-S may be formed between the light transmitting plate 351 and the elastic body 352.

The light transmitting plate 351 may be formed as a rectangular plane having a long side in a first direction and a short side in a second direction that intersects the first direction. A corner where the long side in the first direction and the short side in the second direction meet may be formed at a right angle. The planar shape of the light transmitting plate 351 and the elastic body 352 is not limited to a square shape, and may be formed in other polygonal, circular, or oval shapes.

The light transmitting plate 351 is formed of a rigid light transmitting material and may pass the laser light emitted from the laser irradiation portion 500. Here, light transparency may be defined as being able to pass more than 80% of the light energy of the laser light emitted from the laser irradiation portion 500. For example, the light transmitting plate 351 may be formed of a material capable of exhibiting light transmittance of about 80% or more for light in a wavelength range of about 250 nm to 5 *µ*m but is not limited thereto.

In some aspects, the light transmitting plate 351 may be formed of any material that may withstand the pressure inside the closed space 350-S, for example, a pressure of about 0.1 MPa to about 5 MPa based on the gauge pressure. The light transmitting plate 351 may be formed of a material such as, for example, tempered glass, quartz, acrylic, metal oxide, or metalloid oxide, such as, for example, silicon oxide or aluminum oxide. However, embodiments of the present disclosure are not limited thereto.

The elastic body 352 may be formed of a light transmitting material having elasticity, which allows laser light emitted from the laser irradiation portion 500 to pass through it. The elastic body 352 is configured to transmit laser light incident a side (e.g., front side) of the elastic body 352 to the another side (e.g., back side) of the elastic body 352. For example, the elastic body 352 may be formed of a silicone multi-layer, a silicone-PET (polyethylene terephthalate) laminated layer, PDMS (polydimethylsiloxane), or the like. However, embodiments of the present disclosure are not limited thereto.

The elastic body 352 expands in a downward direction, that is, in the direction of the photomask 310, due to the pressure inside the closed space 350-S, thereby generating a pressing force in the downward direction.

The gas pressure regulator 353 may supply gas to the closed space 350-S between the light transmitting plate 351 and the elastic body 352.

The gas pressure regulator 353 may supply a gas into the closed space 350-S that is inert or extremely chemically reactive and capable of transmitting a laser beam, such as, for example, nitrogen (N), helium (He), neon (Ne), argon (Ar), carbon dioxide (CO₂), or mixtures thereof. Hereinafter, gases that are inert or have extremely low chemical reactivity are collectively referred to as neutral gas.

The gas pressure regulator 353 may include a reservoir for storing gas, a gas pump for generating pressure and supplying the gas, and a gas valve for controlling the flow of the gas. The gas pump may be configured to supply the gas into the closed space 350-S at an increased pressure compared to the external pressure of the closed space 350-S.

The gas valve may stop the supply of gas when the pressure inside the closed space 350-S is sufficiently high and close the closed space 350-S such that the pressure inside the closed space 350-S is maintained. The gas valve may be, for example, a ball valve, a globe valve, a gate valve, a control valve, or the like but is not particularly limited.

The gas conduit 354 connects the gas pressure regulator 353 and the closed space 350-S and provides a path for gas to move. Gas may move between the gas pressure regulator 353 and the closed space 350-S by the gas conduit 354.

In an embodiment, the gas conduit 354 may be formed penetrating the holding frame 355, but embodiments of the present disclosure are not limited thereto. For example, the gas conduit 354 may be formed through elastic body 352.

The holding frame 355 may fix both ends of the light transmitting plate 351 and the elastic body 352.

FIG. 9 is a front view illustrating a shape of the light blocking layer of the photo mask illustrated in FIGS. 7 and 8.

Referring to FIGS. 7 and 9, a light blocking pattern layer 312 of the photomask 310 may be disposed on an outer area of the photomask 310 that overlaps with the non-display area NDA, which is an outer area of the display substrate 20, except for the display area DPA of the display substrate 20 in which the plurality of light emitting elements LE are arranged.

The light blocking pattern layer 312 is disposed on one side of the base layer 311, and the light blocking pattern layer 312 may include an opening 312-O corresponding to the display area DPA of the display substrate 20.

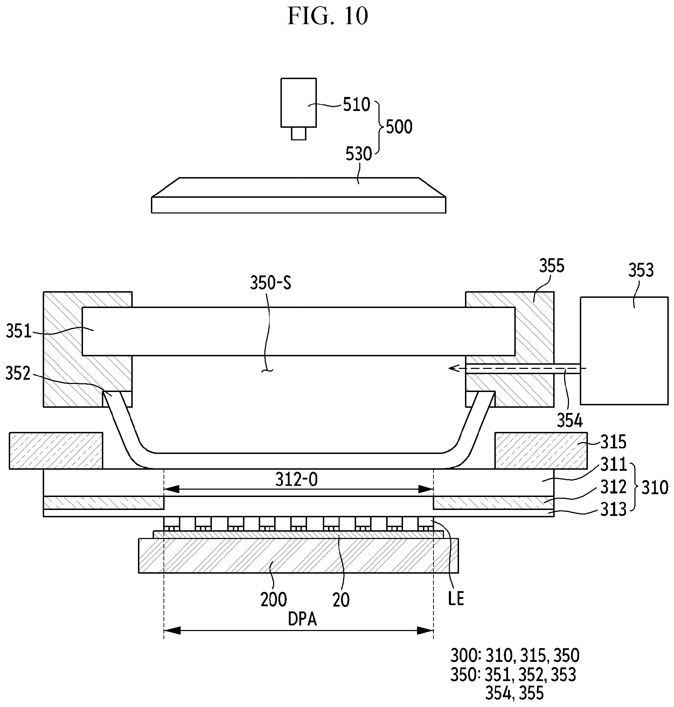

FIGS. 10 to 12 are cross-sectional views of one side illustrating a micro LED transfer method using a manufacturing device In an embodiment.

Referring to FIG. 10, the pressing member 350 may first be disposed on the front of the photomask 310 and may be moved in the direction of the display substrate 20 approaching the display substrate 20.

In some aspects, the photomask 310 may be disposed on the display substrate 20. Further, the opening 312-O defined by the light blocking pattern layer 312 of the photomask 310 and the display area DPA of the display substrate 20 may be aligned. Since the photomask 310 is lighter and more mobile than the pressing member 350, alignment with the display substrate 20 is easy and precision may be improved.

The gas pressure regulator 353 opens a gas valve and fills the closed space 350-S between the light transmitting plate 351 and the elastic body 352 with gas through the gas conduit 354. As the gas is filled in the closed space 350-S, the pressure inside the closed space 350-S increases, such that the elastic body 352 expands in a downward direction, that is, in the direction of the display substrate 20, and generates a pressing force in the downward direction.

The elastic body 352 expands downward by filling with gas, and uniform pressure may be applied to the surface of the light emitting element LE disposed on the display substrate 20. In some embodiments, when the light transmitting plate 351 presses the display substrate 20 on the photomask 310 without the elastic body 352, thermal deformation may occur in the light transmitting plate 351 and the press uniformity of the display substrate 20 may deteriorate due to irradiation of laser light.

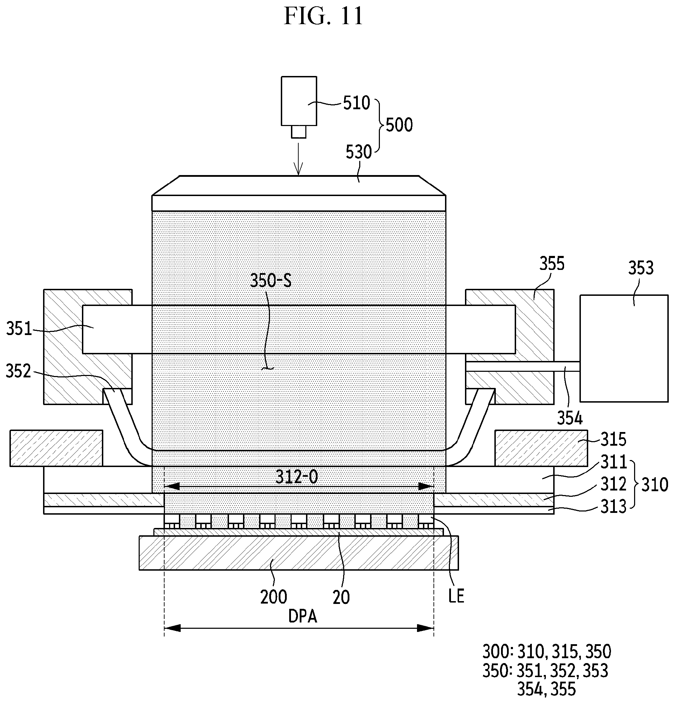

Referring to FIG. 11, a laser irradiation portion 500 emits and radiates laser light in the direction of the photomask 310 on the bottom surface. Here, the light emitted and radiated from the laser irradiation portion 500 passes through the opening 312-O defined by the light blocking pattern layer 312 and is applied to the plurality of light emitting elements LE arranged on the display substrate 20. That is, for example, based on the light blocking pattern layer 312, the laser light that passes through the opening 312-O corresponding to the display area DPA is applied to the plurality of light emitting elements LE arranged on the display substrate 20.

In some embodiments, the laser light applied to the light blocking pattern layer 312 corresponding to the non-display area NDA of the display substrate 20 does not pass through the light blocking pattern layer 312. Accordingly, embodiments of the present disclosure support preventing the laser light from irradiating certain portions of the display substrate 20. For example, embodiments of the present disclosure may prevent damage to the display substrate 20 that may occur when laser light irradiates the non-display area NDA of the display substrate 20 where bonding is not desired or required.

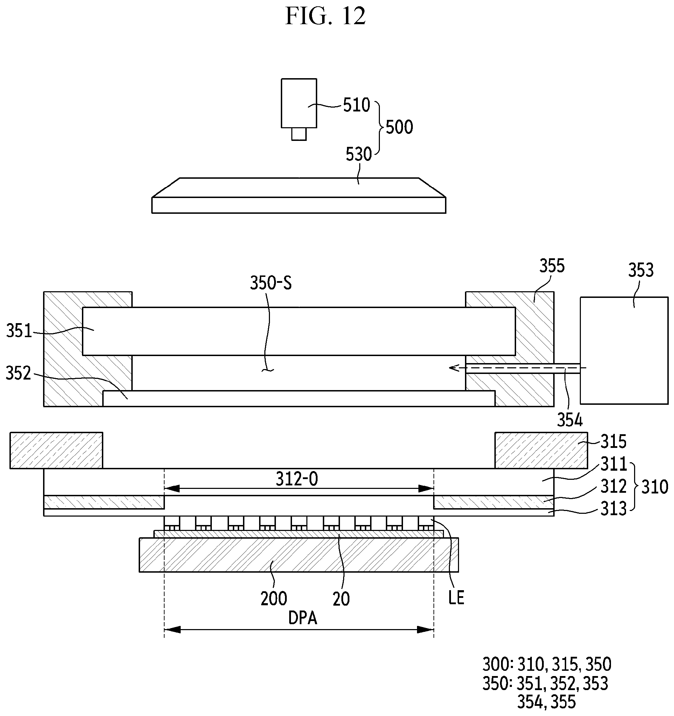

Referring to FIG. 12, when laser irradiation is completed by the laser irradiation portion 500, a gas pressure regulator 353 (also referred to herein as a gas pressure adjustment member) may lower the pressure of the closed space 350-S by discharging gas in the closed space 350-S. In an example in which the pressure of the closed space 350-S is lowered, the elastic body 352 that was expanded downward returns to its original state, thereby lowering the pressing force.

Thereafter, a plate transfer member 320 may move the light transmitting plate 351 in a direction away from the display substrate 20.

According to one embodiment, even in the case of a large area display substrate 20, equal pressure distribution is possible when bonding the light emitting elements LE on the display substrate 20 using a laser.

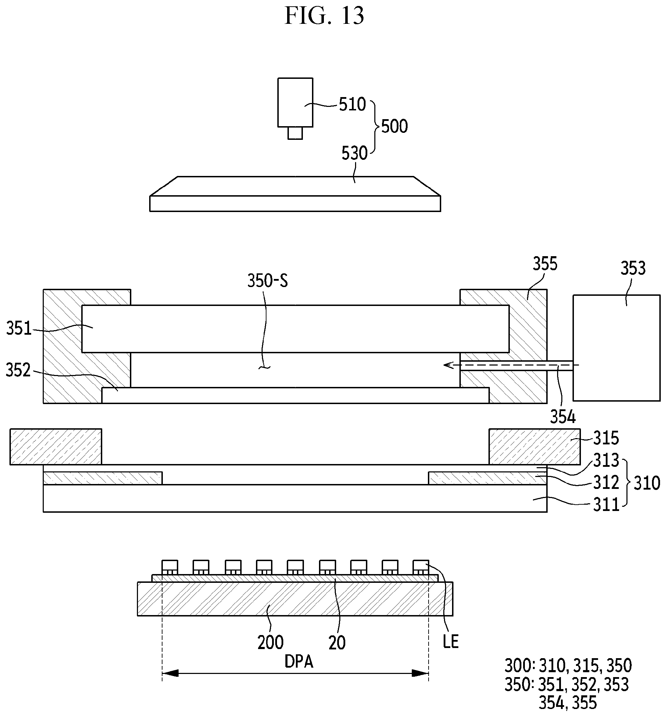

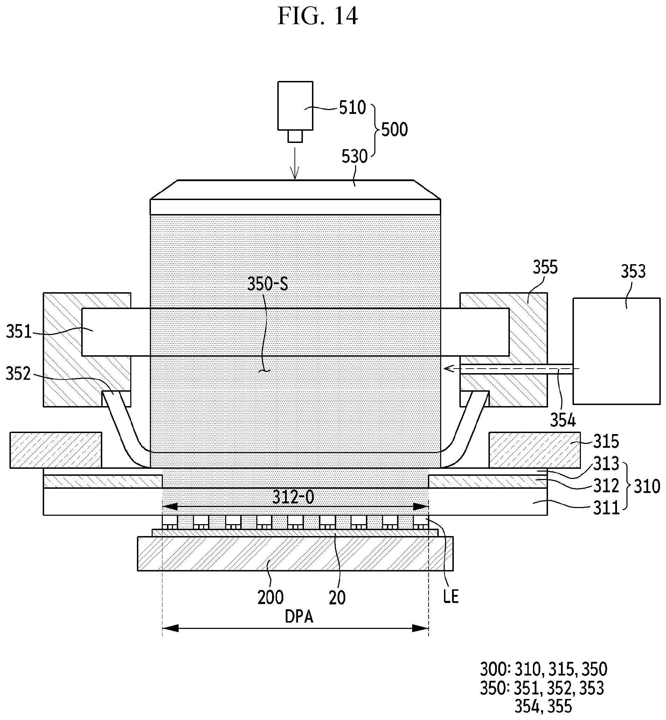

FIG. 13 is a side cross-sectional view schematically illustrating a manufacturing device for a display panel according to another embodiment. FIG. 14 is a side cross-sectional view illustrating a micro LED transfer method using a manufacturing device for a display panel FIG. 13.

Referring to FIGS. 13 and 14, the light blocking pattern layer 312 of the photomask 310 differs from the manufacturing device for the display panel described with reference to FIGS. 7 to 12 in that the light blocking pattern layer 312 is disposed such that the light blocking pattern layer 312 faces the laser irradiation portion 500. Descriptions duplicated with the embodiments of FIGS. 7 to 12 will be omitted.

Referring to FIG. 13, the photomask 310 may be formed of a plurality of layers. The photomask 310 may include a base layer 311 and a light blocking pattern layer 312. In some aspects, the photomask 310 may further include a protective layer 313 on the light blocking pattern layer 312, but the protective layer 313 may be omitted.

The base layer 311 may be arranged such that the base layer 311 faces the support portion 200. The base layer 311 is formed in the form of a transparent or translucent flat plate, including at least one transparent material such as, for example, glass, quartz, silicon, or the like. The base layer 311 allows laser light to transmit to the front or back side in the opposite direction. The base layer 311 is configured to transmit laser light incident a side (e.g., front side) of the base layer 311 to the another side (e.g., back side) of the base layer 311.

The base layer 311 may cover the entire display substrate 20 on a plane surface.

The light blocking pattern layer 312 is disposed on one side of the base layer 311 and includes a pattern having light blocking properties. The light blocking pattern layer 312 may be disposed on the front surface of the base layer 311 and may be disposed such that the light blocking pattern layer 312 faces the laser irradiation portion 500. The thickness of the light blocking pattern layer 312 is not particularly limited but may have a film thickness within the range of 80 nm to 180 nm. Because if the light blocking pattern layer 312 is too thin, it becomes difficult to obtain the desired light blocking properties, and if the light blocking pattern layer 312 is too thick, it becomes difficult to process the light blocking pattern with high precision.

The light blocking pattern layer 312 may be any material having light blocking properties, but is not particularly limited to, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. In an embodiment, chromium (Cr) is selected for the light blocking pattern layer 312.

The light blocking pattern layer 312 includes one opening. The laser beam may penetrate the opening. Accordingly, the opening may define a transmission area for the laser beam. Here, the light emitted and radiated from the laser irradiation portion 500 passes through the opening of the light blocking pattern layer 312 and is applied to the plurality of light emitting elements LE arranged on the display substrate 20.

When the light blocking pattern layer 312 is separated from the light emitting element LE, light may be diffracted at the boundary of the opening, resulting in an error between the opening and the laser beam transmission area.

The protective layer 313 is disposed on the base layer 311 on which the light blocking pattern layer 312 is provided, and the protective layer 313 may protect the surface of the light blocking pattern layer 312 and prevent damage to the light blocking pattern layer 312. The thickness of the protective layer 313 is not particularly limited but may have a thickness within the range of approximately 2 to 3 µm. The protective layer 313 may include a transparent material, such as, for example, a transparent or translucent material, such as, for example, a transparent resin.

The mounting member 315 may be attached to an outer surface of the photomask 310. For example, the mounting member 315 may be attached to the entire outer surface of the protective layer 313. The mounting member 315 may be, for example, any one of an electrostatic chuck, an adhesive chuck, a vacuum chuck, or a porous vacuum chuck. In some aspects, the mounting member 315 may be a clamp but is not limited thereto. The mounting member 315 does not overlap the path of the laser light.

Referring to FIG. 14, the gas pressure regulator 353 opens a gas valve and fills the closed space 350-S between the light transmitting plate 351 and the elastic body 352 with gas through the gas conduit 354. As the gas is filled in the closed space 350-S, the pressure inside the closed space 350-S increases and expands in a downward direction, that is, toward the display substrate 20, generating a pressing force in the downward direction.

The elastic body 352 expands downward by filling with gas, and uniform pressure may be applied to the surface of the light emitting element LE disposed on the display substrate 20.

The laser irradiation portion 500 emits and radiates laser light in the direction of the light transmitting plate 351 on the bottom surface. Here, the light emitted and radiated from the laser irradiation portion 500 passes through the opening 312-O defined by the light blocking pattern layer 312 and is applied to the plurality of light emitting elements LE arranged on the display substrate 20. That is, for example, based on the light blocking pattern layer 312, the laser light that passes through the opening 312-O corresponding to the display area DPA may be applied to the plurality of light emitting elements LE arranged on the display substrate 20.

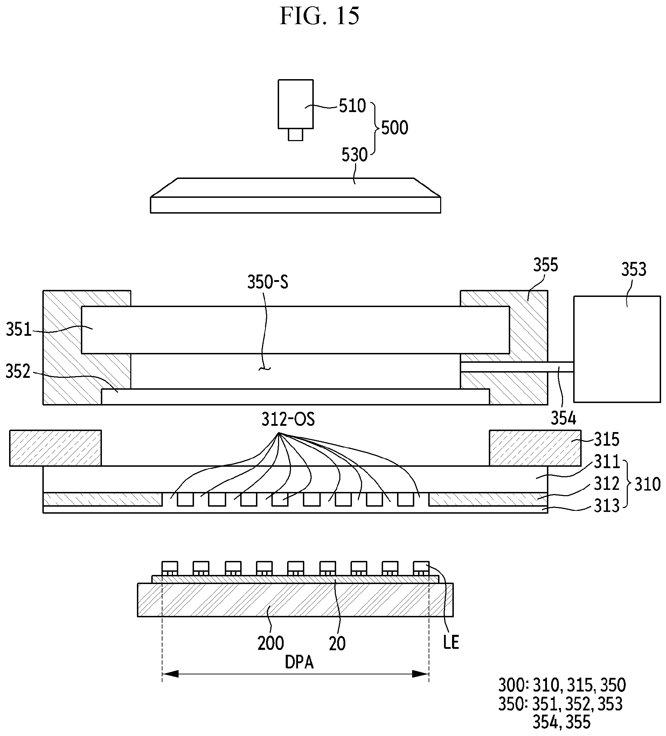

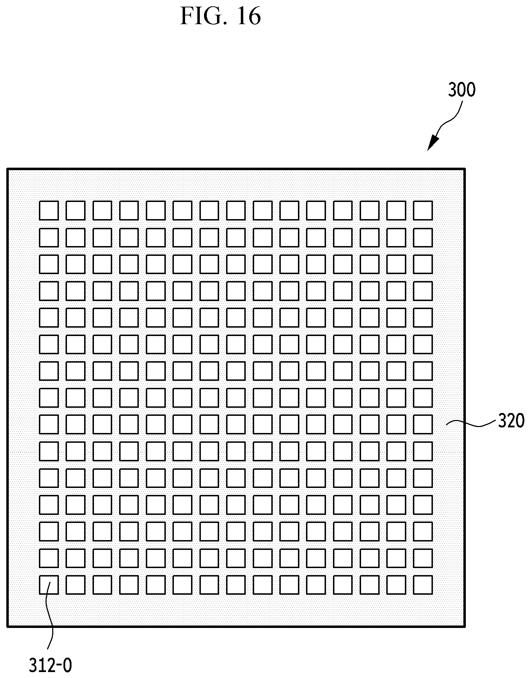

FIG. 15 is a side cross-sectional view schematically illustrating a manufacturing device for a display panel according to another embodiment. FIG. 16 is a front view illustrating a shape of the light blocking layer of the photo mask illustrated in FIG. 15.

Referring to FIGS. 15 and 16, the light blocking pattern layer 312 of the photomask 310 differs from FIGS. 7 to 11 in that the light blocking pattern layer 312 has openings corresponding to areas between the light emitting elements LE, except for the areas corresponding to the light emitting element LE arranged on the display substrate 20. Descriptions duplicated with the embodiments of FIGS. 7 to 12 will be omitted.

The light blocking pattern layer 312 of the photomask 310 may be disposed in an outer area of the photomask 310 that overlaps the non-display area NDA, which is an outer area of the display substrate 20 excluding the display area DPA of the display substrate 20 where a plurality of light emitting elements LE are arranged.

Referring to FIGS. 15 and 16, the photomask 310 may be formed of a plurality of layers. The photomask 310 may include a base layer 311 and a light blocking pattern layer 312. In some aspects, the photomask 310 may further include a protective layer 313 on the light blocking pattern layer 312, but the protective layer 313 may be omitted.

The base layer 311 may be arranged such that the base layer 311 faces the support portion 200. The base layer 311 is formed in the form of a transparent or translucent flat plate, including at least one transparent material such as, for example, glass, quartz, silicon, or the like. The base layer 311 allows laser light to transmit to the front or back side in the opposite direction.

The light blocking pattern layer 312 is disposed on one side of the base layer 311 and includes a pattern having light blocking properties. The thickness of the light blocking pattern layer 312 is not particularly limited but may have a film thickness within the range of 80 nm to 180 nm. Because if the light blocking pattern layer 312 is too thin, it becomes difficult to obtain the desired light blocking properties, and if the light blocking pattern layer 312 is too thick, it becomes difficult to process the light blocking pattern with high precision.

The light blocking pattern layer 312 is not particularly limited as long as the light blocking pattern layer 312 is a material having light blocking properties, but may include, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. In an embodiment, chromium (Cr) is selected for the light blocking pattern layer 312.

The light blocking pattern layer 312 may be disposed to correspond to the non-display area NDA, which is an outer area of the display substrate 20 excluding the display area DPA of the display substrate 20 where a plurality of light emitting elements LE are arranged on the base layer 311. Further, the light blocking pattern layer 312 may be disposed on the base layer 311 to correspond to areas between the light emitting elements LE, excluding areas corresponding to the light emitting elements LE arranged on the display substrate 20. In other words, the light blocking pattern layer 312 may include openings 312-OS corresponding to the light emitting elements LE arranged on the display substrate 20.

In other words, the light blocking pattern layer 312 is disposed on one side of the base layer 311 in a planar shape and the light blocking pattern layer 312 may include light blocking pattern layers 312 that partially block emitted laser light, such that the emitted laser light irradiates the light emitting elements LE arranged on the display substrate 20, without irradiating other portions of the display substrate 20.

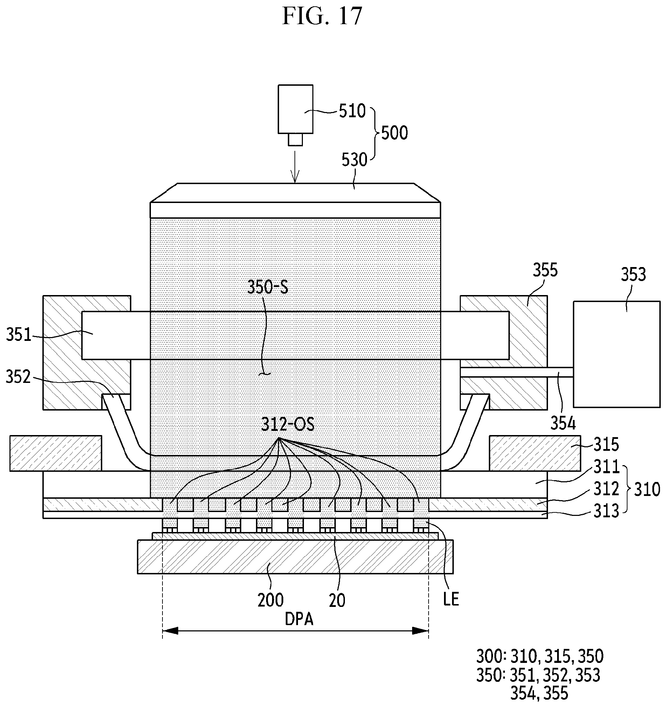

FIG. 17 is a cross-sectional view of one side illustrating a micro LED transfer method using the manufacturing device illustrated in FIG. 16.

Referring to FIGS. 16 and 17, a pressing member 350 expands the elastic body 352 in the direction of the display substrate 20 to display a plurality of light emitting elements LE arranged on the display substrate 20. Based on the expansion, the elastic body 352 may press against the display substrate 20, and the plurality of light emitting elements LE arranged on the display substrate 20 may be pressed against the display substrate 20.

In some embodiments, the laser irradiation portion 500 emits laser light, irradiating the display substrate 20 with the laser light through the photomask 310. In particular, the laser irradiation portion 500 emits and radiates laser light in the direction of the support portion 200 on the bottom surface, and the light emitted and radiated from the laser irradiation portion 500 passes through the openings 312-OS of the photomask 310 and is applied to the plurality of light emitting elements LE arranged on the display substrate 20.

In some embodiments, the laser light applied to the light blocking pattern layer 312 of the photomask 310 does not pass through the light blocking pattern layer 312. Accordingly, among the laser light emitted and radiated from the laser irradiation portion 500, based on the light blocking pattern layer 312, the light transmitted through the openings of the light blocking pattern layer 312 is applied to the plurality of light emitting elements LE arranged on the display substrate 20, and not to other portions of the display substrate 20. That is, for example, only the laser light that passes through the openings 312-OS of the photomask 310 may be applied to the plurality of light emitting elements LE arranged on the display substrate 20.

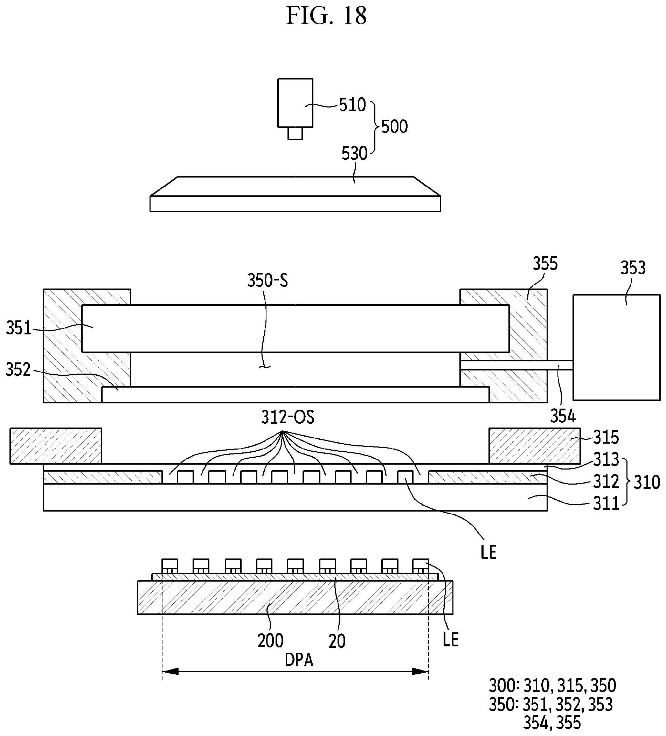

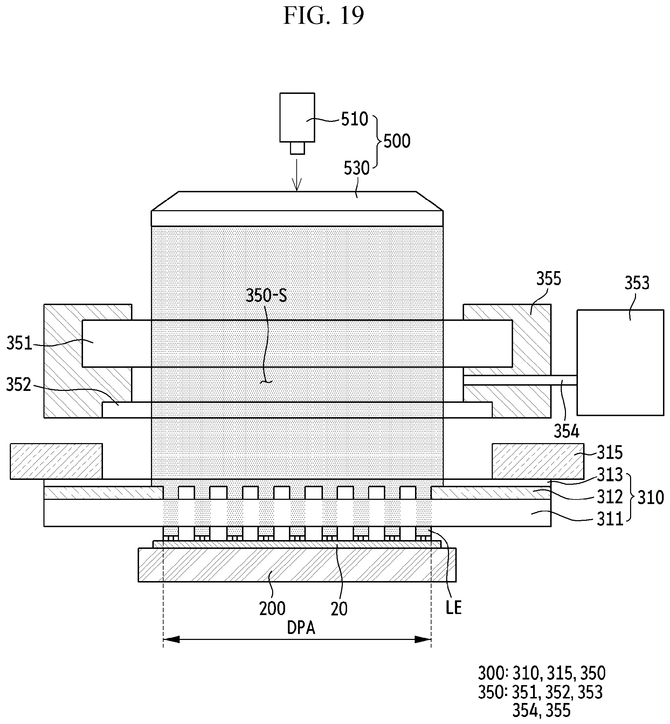

FIG. 18 is a side cross-sectional view schematically illustrating a manufacturing device for a display panel according to another embodiment. FIG. 19 is a side cross-sectional view illustrating a micro LED transfer method using a manufacturing device for a display panel of FIG. 18.

Referring to FIGS. 18 and 19, a light blocking pattern layer 312 of the photomask 310 differs from the manufacturing device for the display panel described with reference to FIGS. 15 to 17 in that the light blocking pattern layer 312 is arranged such that the light blocking pattern layer 312 faces the laser irradiation portion 500. Descriptions overlapping with the embodiments of FIGS. 15 to 17 will be omitted.

Referring to FIGS. 18 and 19, the light blocking pattern layer 312 is disposed on one surface of the base layer 311 and includes a pattern having light blocking properties. The light blocking pattern layer 312 is disposed on one side of the base layer 311 and includes a pattern having light blocking properties. The light blocking pattern layer 312 may be disposed on the front surface of the base layer 311 and may be disposed such that the light blocking pattern layer 312 faces the laser irradiation portion 500. The thickness of the light blocking pattern layer 312 is not particularly limited but may have a film thickness within the range of 80 nm to 180 nm. Because if the light blocking pattern layer 312 is too thin, it becomes difficult to obtain the desired light blocking properties, and if the light blocking pattern layer 312 is too thick, it becomes difficult to process the light blocking pattern with high precision.

The light blocking pattern layer 312 is not particularly limited as long as the light blocking pattern layer 312 is a material having light blocking properties, but may include, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. In an embodiment, chromium (Cr) is selected for the light blocking pattern layer 312.

The light blocking pattern layer 312 may be disposed to correspond to the non-display area NDA, which is an outer area of the display substrate 20 excluding the display area DPA of the display substrate 20 where a plurality of light emitting elements LE are arranged on the base layer 311. Further, the light blocking pattern layer 312 may be disposed on the base layer 311 to correspond to areas between the light emitting elements LE, excluding areas corresponding to the light emitting elements LE arranged on the display substrate 20. In other words, the light blocking pattern layer 312 may include openings 312-OS corresponding to the light emitting elements LE arranged on the display substrate 20.

In other words, the light blocking pattern layer 312 is disposed on one side of the base layer 311 in a planar shape, and the light blocking pattern layer 312 may include light blocking pattern layers 312 corresponding to the light emitting elements LE arranged on the display substrate 20.

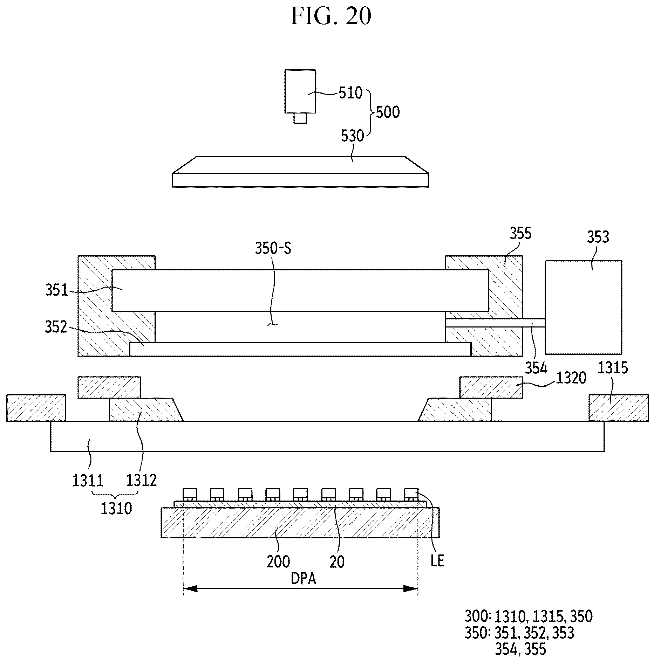

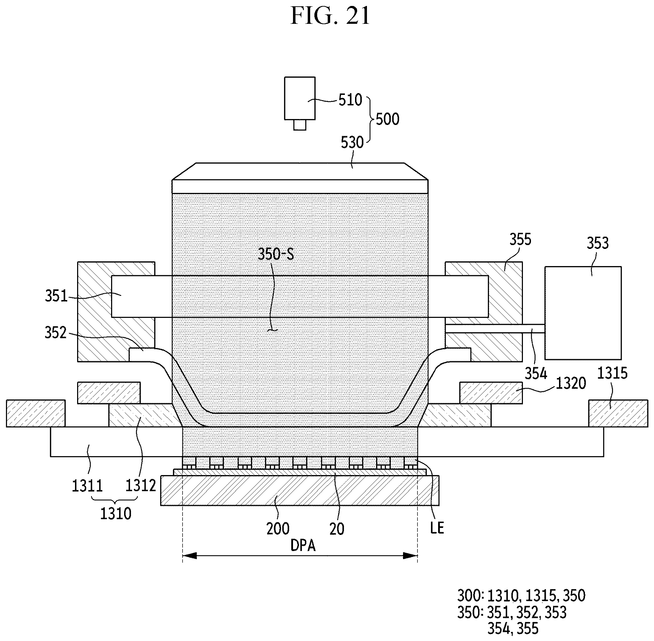

FIG. 20 is a side cross-sectional view schematically illustrating a manufacturing device for a display panel according to another embodiment. FIG. 21 is a side cross-sectional view illustrating a micro LED transfer method using a manufacturing device for a display panel of FIG. 20.

Referring to FIGS. 20 and 21, the manufacturing device for the display panel differs from the manufacturing device for the display panel described with reference to FIGS. 13 and 14 in that the manufacturing device includes a metal mask assembly 1310 in place of the photomask 310. Descriptions overlapping with the embodiments of FIGS. 13 and 14 will be omitted.

Referring to FIGS. 20 and 21, a pressing portion 300 may include a metal mask assembly 1310, a mounting member 1315, a mask frame 1320, and a pressing member 350.

The metal mask assembly 1310 may include a light transmitting layer 1311 and a metal mask 1312. The light transmitting layer 1311 is formed in the form of a transparent or translucent flat plate including at least one transparent material, such as, for example, glass, quartz, silicone, and the like. The light transmitting layer 1311 may also be formed of silicone multi-layers, silicone-PET (polyethylene terephthalate) laminated layers, PDMS (polydimethylsiloxane), and the like.

The light transmitting layer 1311 allows laser light to transmit to the front or back side in the opposite direction. The light transmitting layer 1311 is configured to transmit laser light incident a side (e.g., front side) of the light transmitting layer 1311 to the another side (e.g., back side) of the light transmitting layer 1311.

The metal mask 1312 may be an open mask disposed on one surface of the light transmitting layer 1311 and including a pattern having light blocking properties. For example, the metal mask 1312 may be placed on the front side of the light transmitting layer 1311 such that the metal mask 1312 faces the laser irradiation portion 500.

The metal mask 1312 is not particularly limited as long as the metal mask 1312 is a material that reflects laser light, but examples include metal materials such as, for example, aluminum.

The metal mask 1312 may have a larger area than the range of the laser emitted and radiated from the laser irradiation portion 500. The metal mask 1312 includes one opening. The laser beam may penetrate the opening. Accordingly, the opening may define a transmission area for the laser beam. Here, the light emitted and radiated from the laser irradiation portion 500 is applied to a plurality of light emitting elements LE arranged on the display substrate 20 through the metal mask 1312, one opening corresponding to the display area DPA of the display substrate 20 is transmitted.

The mounting member 1315 may be attached to an outer surface of the light transmitting layer 1311. For example, the mounting member 1315 may be disposed on the entire outer surface of the light transmitting layer 1311. The mounting member 1315 may be, for example, any one of an electrostatic chuck, an adhesive chuck, a vacuum chuck, and a porous vacuum chuck. In some aspects, the mounting member 1315 may be a clamp but is not limited thereto. The mounting member 315 does not overlap the path of the laser light.

The mask frame 1320 may be attached to an outer surface of the metal mask 1312. For example, the mask frame 1320 may be attached to the front of the metal mask 1312. The mask frame 1320 does not overlap the path of the laser light.

The pressing member 350 is disposed on the front of the metal mask assembly 1310 and may move in a direction toward the display substrate 20 that approaches the display substrate 20.

The pressing member 350 may include a light transmitting plate 351, an elastic body 352, a gas pressure regulator 353, a gas conduit 354, and a holding frame 355.

The gas pressure regulator 353 opens a gas valve and fills the closed space 350-S between the light transmitting plate 351 and the elastic body 352 with gas through the gas conduit 354.

As the gas is filled in the closed space 350-S, the pressure inside the closed space 350-S increases and expands in a downward direction, that is, toward the display substrate 20, generating a pressing force in the downward direction.

As the elastic body 352 expands in the downward direction due to the gas filling, pressure is applied to the light transmitting layer 1311 through the opening in the metal mask assembly 1310.

The metal mask assembly 1310 may be disposed on the display substrate 20. Further, the opening defined by the metal mask 1312 of the metal mask assembly 1310 and the display area DPA of the display substrate 20 may be aligned. The metal mask assembly 1310 is lighter than the pressing member 350, which may support reduced complexity associated with aligning the metal mask assembly 1310 with the display substrate 20, and alignment precision may be improved.

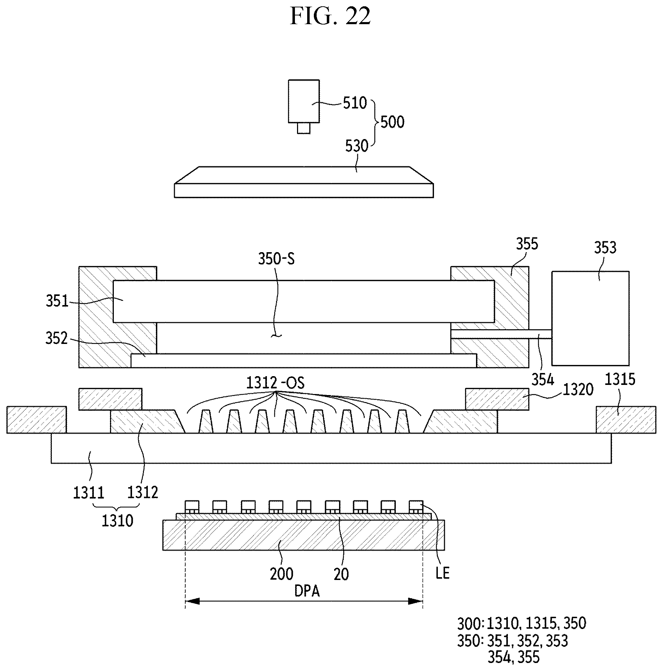

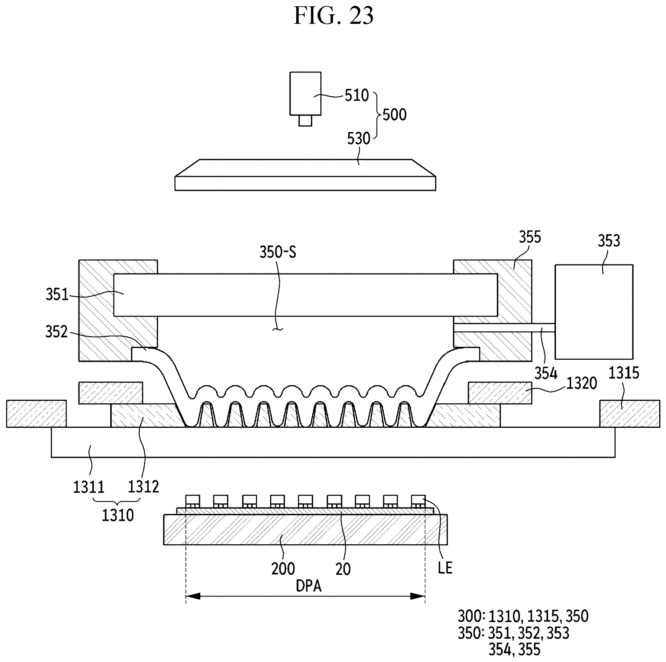

FIG. 22 is a side cross-sectional view schematically illustrating a manufacturing device for a display panel according to another embodiment. FIG. 23 is a side cross-sectional view illustrating a micro LED transfer method using a manufacturing device for a display panel of FIG. 22.

Referring to FIGS. 22 and 23, the metal mask 1312 of the metal mask assembly 1310 differs from FIGS. 20 and 21 in that the metal mask 1312 has openings corresponding to areas between the light emitting element LE, except for the areas corresponding to the light emitting elements LE arranged on the display substrate 20. Descriptions duplicated with the embodiments of FIGS. 20 and 21 will be omitted.

The metal mask 1312 of the metal mask assembly 1310 may overlap the non-display area NDA, which is an outer area of the display substrate 20 excluding the display area DPA of the display substrate 20 where a plurality of light emitting elements LE are arranged,

The metal mask 1312 may be a fine metal mask disposed on one side of the light transmitting layer 1311 and including a pattern having light blocking properties. For example, the metal mask 1312 may be placed on the front side of the light transmitting layer 1311 such that the metal mask 1312 faces the laser irradiation portion 500.

The metal mask 1312 may be disposed to correspond to the non-display area NDA, which is an outer area of the display substrate 20, excluding the display area DPA of the display substrate 20 where a plurality of light emitting elements LE are disposed. Further, the metal mask 1312 may be disposed on the light transmitting layer 1311 to correspond to areas between the light emitting elements LE, excluding areas corresponding to the light emitting elements LE arranged on the display substrate 20. That is, the metal mask 1312 may include openings 1312-OS corresponding to the light emitting elements LE arranged on the display substrate 20.

In other words, the metal mask 1312 is disposed in a planar shape on one side of the flat light transmitting layer 1311 and the metal mask 1312 may include metal masks 1312 corresponding to the light emitting elements LE arranged on the display substrate 20.

The metal mask 1312 may have a slope at the side of the opening. The metal mask 1312 may have different widths at the top and bottom of the openings. For example, the width of the opening of the metal mask 1312 may become wider toward the top.

The pressing member 350 may be disposed on the front of the metal mask assembly 1310 and may move in a direction toward the display substrate 20 that approaches the display substrate 20.

The pressing member 350 may include a light transmitting plate 351, an elastic body 352, a gas pressure regulator 353, a gas conduit 354, and a holding frame 355.

The gas pressure regulator 353 may open a gas valve to fill the closed space 350-S between the light transmitting plate 351 and the elastic body 352 with gas through the gas conduit 354.

As the gas is filled in the closed space 350-S, the pressure inside the closed space 350-S increases and expands in a downward direction, that is, toward the display substrate 20, generating a pressing force in the downward direction.

The elastic body 352 expands downward by filling with gas and may apply pressure to the light transmitting layer 1311 through the metal mask assembly 1310. In an example in which the elastic body 352 expanded downward, the elastic body 352 may have a concave-convex shape along the openings of the metal mask assembly 1310. For example, the area overlapping the opening of the metal mask assembly 1310 may be relatively concave downward, and the area overlapping the pattern between the openings may be relatively convex upward.

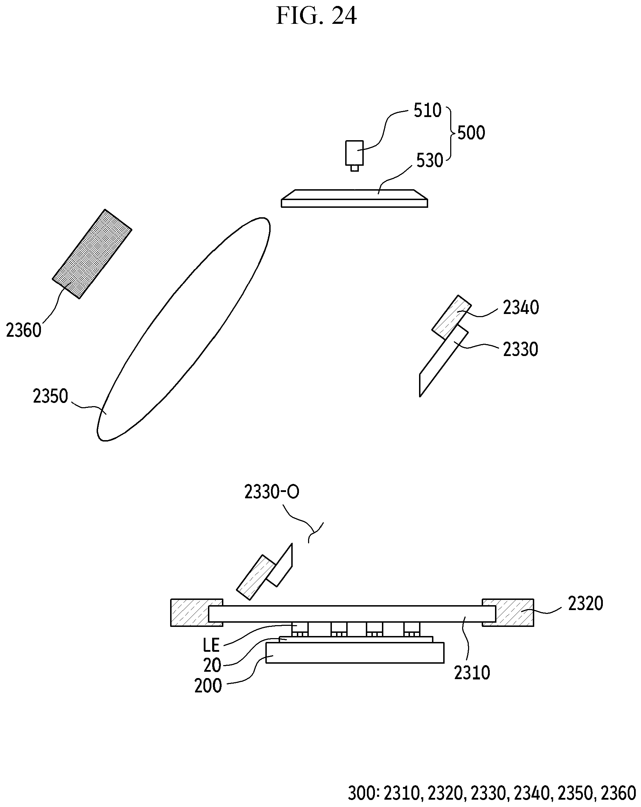

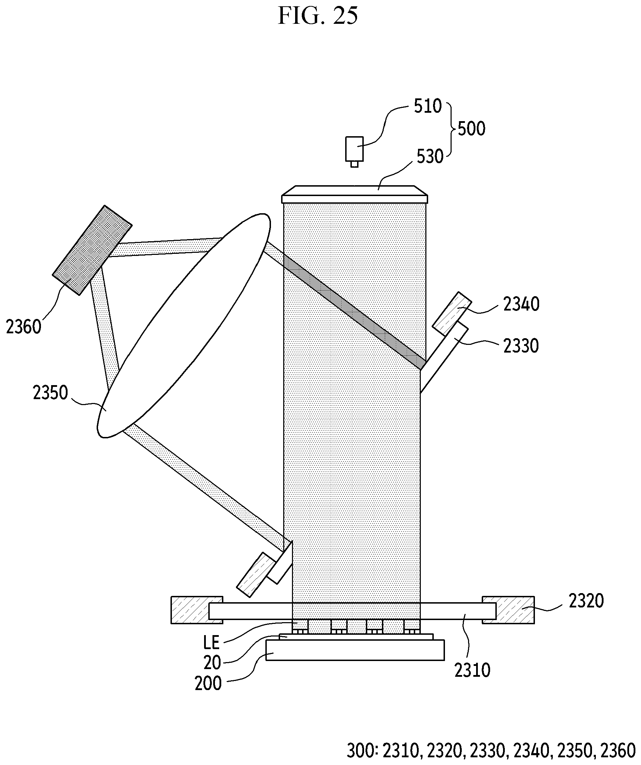

FIG. 24 is a side cross-sectional view schematically illustrating a manufacturing device for a display panel according to another embodiment. FIG. 25 is a side cross-sectional view illustrating a micro LED transfer method using a manufacturing device for a display panel of FIG. 24.

Referring to FIGS. 24 and 25, the manufacturing device for a display panel may include a support portion 200, a pressing portion 300, and a laser irradiation portion 500. Since the support portion 200 and the laser irradiation portion 500 have been described with reference to FIGS. 7 to 11, detailed description will be omitted.

Referring to FIGS. 24 and 25, the pressing portion 300 may include a pressing plate 2310, a plate transfer member 2320, a reflective mask 2330, a mask frame 2340, an optical member 2350, and a light absorbing member 2360.

The pressing plate 2310 is spaced apart from the support portion 200 in the third direction DR3 and is disposed on the front of the support portion 200 and at least one of the lateral outer peripheral surfaces and the front and rear outer surfaces of the pressing plate 2310 is coupled to the plate transfer member 2320 on the side.

The pressing plate 2310 is formed in the form of a transparent or translucent flat plate including at least one transparent material such as, for example, glass, quartz, silicone, or the like. The pressing plate 2310 allows laser light applied to the front or back surface to be transmitted to the front or back in the opposite direction. The pressing plate 2310 is configured to transmit laser light incident a surface (e.g., front surface) of the pressing plate 2310 to the another surface (e.g., back surface) of the pressing plate 2310.

The pressing plate 2310 may be moved by the plate transfer member 2320 in a direction toward the display substrate 20 that is closer to the display substrate 20 or in an opposite direction away from the display substrate 20. The pressing plate 2310 moves in the direction of the display substrate 20 closer to the display substrate 20 by the plate transfer member 2320 and a plurality of light emitting elements LE arranged on the display substrate 20 may be pressed in the direction of the display substrate 20.

The plate transfer member 2320 is disposed on at least one side of the pressing plate 2310 and is coupled to at least one of the outer peripheral surface of the pressing plate 2310 in the lateral direction and the outer front and back surfaces of the pressing plate 2310.

The plate transfer member 2320 includes at least one transfer module and can be moved by the at least one transfer module in a direction toward the support portion 200 that is closer to the support portion 200, or in an opposite direction that is further away from the support portion 200. Accordingly, the plate transfer member 2320 may be coupled to the pressing plate 2310 disposed on the front of the support portion 200 and may move the pressing plate 2310 in a direction toward the display substrate 20 that approaches the display substrate 20 or in an opposite direction away from the display substrate 20. The plate transfer member 2320 may move the pressing plate 2310 in the direction of the display substrate 20 to press the plurality of light emitting elements LE arranged on the display substrate 20 onto the display substrate 20 with the pressing plate 2310. The transfer module of the plate transfer member 2320 may include at least one conveyor, motor, chain, roller, gear, or the like.

The reflective mask 2330 may be an open mask that is disposed on one surface of the pressing plate 2310 and includes a pattern having light blocking properties. The reflective mask 2330 may be disposed between the pressing plate 2310 and the laser irradiation portion 500. The reflective mask 2330 may be arranged such that the reflective mask 2330 is inclined with respect to the pressing plate 2310. For example, the reflective mask 2330 may be arranged such that the distance between the pressing plates 2310 increases from one end to the other end.

The reflective mask 2330 is not particularly limited to being a material that reflects laser light, but may be, for example, a metallic material such as, for example, aluminum or the like.

The reflective mask 2330 may have a larger area than the range of the laser emitted and radiated from the laser irradiation portion 500. The reflective mask 2330 includes one opening. The laser beam may penetrate the opening. Accordingly, the opening may define a transmission area for the laser beam. Here, the light emitted and radiated from the laser irradiation portion 500 is directed by the reflective mask 2330 through the one opening corresponding to the display area DPA of the display substrate 20 to the plurality of light emitting elements LE arranged on the display substrate 20.

The reflective mask 2330 may overlap the non-display area NDA, which is an outer area of the display substrate 20, and the outer area of the pressing plate 2310 corresponding to the non-display area NDA in the thickness direction excluding the display area DPA of the display substrate 20 where the plurality of light emitting elements LE are arranged,
The mask frame 2340 may be attached to an outer surface of the reflective mask 2330 and support the reflective mask 2330. For example, the mask frame 2340 may be attached to the front of the reflective mask 2330. The mask frame 2340 does not overlap the path of the laser light.

The optical member 2350 and the light absorbing member 2360 may be disposed parallel to the direction in which the reflective mask 2330 is tilted. The optical member 2350 and the light absorbing member 2360 may be disposed at a preset inclination such that the optical member 2350 and the light absorbing member 2360 face the direction in which the reflective mask 2330 is disposed. For example, the light absorbing member 2360 is disposed on the path of light emitted from the laser irradiation portion 500 and reflected by the reflective mask 2330. The light absorbing member 2360 and the optical member 2350 are disposed so as not to overlap the path of light emitted and radiated from the laser irradiation portion 500.

The optical member 2350 may serve to focus incident light and may include one or more lenses. The optical member 2350 is disposed between the reflective mask 2330 and the light absorbing member 2360 to be inclined in the direction in which the light absorbing member 2360 is disposed.

Since light is focused by the optical member 2350, the light absorbing member 2360 may have a smaller area than the opening 2330-O of the reflective mask 2330.

According to one embodiment, a portion of the laser emitted and radiated from the laser irradiation portion 500 may be applied to the display area DA of the display substrate 20 through the opening of the reflective mask 2330, and a portion of the laser irradiation from the laser irradiation portion 500 may be applied to the reflective mask 2330 corresponding to the non-display area NDA of the display substrate 20 and reflected. The light reflected from the reflective mask 2330 may be focused through the optical member 2350 and absorbed by the light absorbing member 2360. Accordingly, among the laser light emitted and radiated from the laser irradiation portion 500, the light transmitted through one opening 2330-O corresponding to the display area DPA of the display substrate 20 may be applied to the plurality of light emitting elements LE arranged on the display substrate 20. That is, only the laser light that passes through the opening 2330-O corresponding to the display area DPA may be applied to the plurality of light emitting elements LE arranged on the display substrate 20.

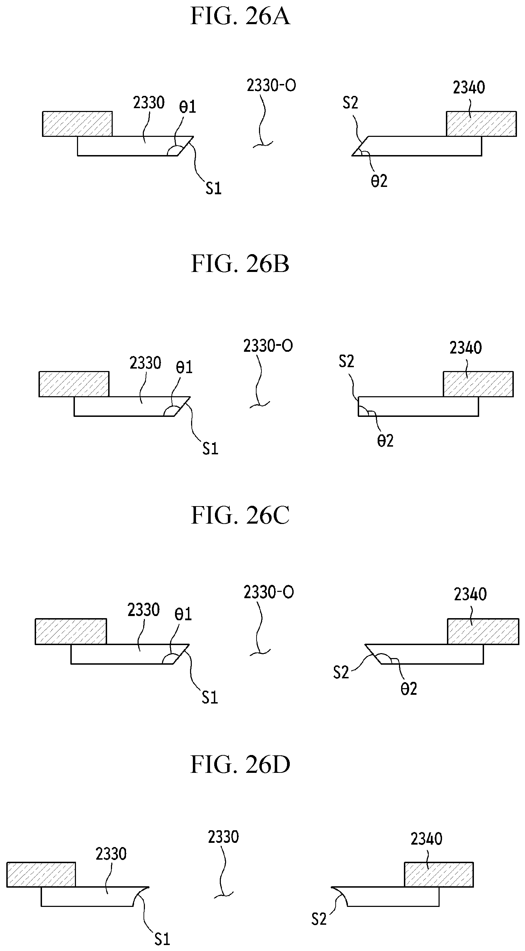

FIGS. 26a to 26d are cross-sectional views of a metal mask according to an embodiment of FIG. 24.

Referring to FIGS. 26a to 26d, the reflective mask 2330 has one opening 2330-O. A side surface of the opening 2330-O of the reflective mask 2330 may have a slope. The opening 2330-O of the reflective mask 2330 may have a first side S1 and a second side S2. The first side S1 and the second side S2 may face each other.

Referring to FIGS. 26a and 26b, a first angle θ1 formed by one surface of the reflective mask 2330 and the first side S1 and the second angle formed by the one surface of the reflective mask 2330 and the second side S2 The angles θ2 may be different from each other. For example, the opening of the reflective mask 2330 may be trapezoidal or parallelogram-shaped.

As illustrated in FIG. 26a, a first angle θ1 formed between one surface of the reflective mask 2330 and the first side S1 is an obtuse angle exceeding 90 degrees and the second angle θ2 formed between one side of the reflective mask 2330 and the second side S2 may be an acute angle of less than 90 degrees. Alternatively, as illustrated in FIG. 26b, the first angle θ1 formed between one surface of the reflective mask 2330 and the first side S1 is an obtuse angle exceeding 90 degrees and the second angle θ2 formed between one side of the reflective mask 2330 and the second side S2 may be a right angle.

Referring to FIGS. 26c and 26d, a first angle θ1 formed by one side of the reflective mask 2330 and the first side S1 may be the same as the second angle θ2 formed by one side of the reflective mask 2330 and the second side S2. As illustrated in FIG. 26c, the first angle θ1 formed between one surface of the reflective mask 2330 and the first side S1 and the second angle θ2 formed by one side of the reflective mask 2330 and the second side S2 may be the same as an obtuse angle exceeding 90 degrees. For example, the opening of the reflective mask 2330 may be an equilateral trapezoid.

As illustrated in FIG. 26d, a first angle θ1 formed between one side of the reflective mask 2330 and the first side S1 and the second angle θ2 formed between one side of the reflective mask 2330 and the second side S2 is an obtuse angle exceeding 90 degrees, but the inclined surface may have a curvature. The slope may become gentler as the slope increases, but is not limited thereto.

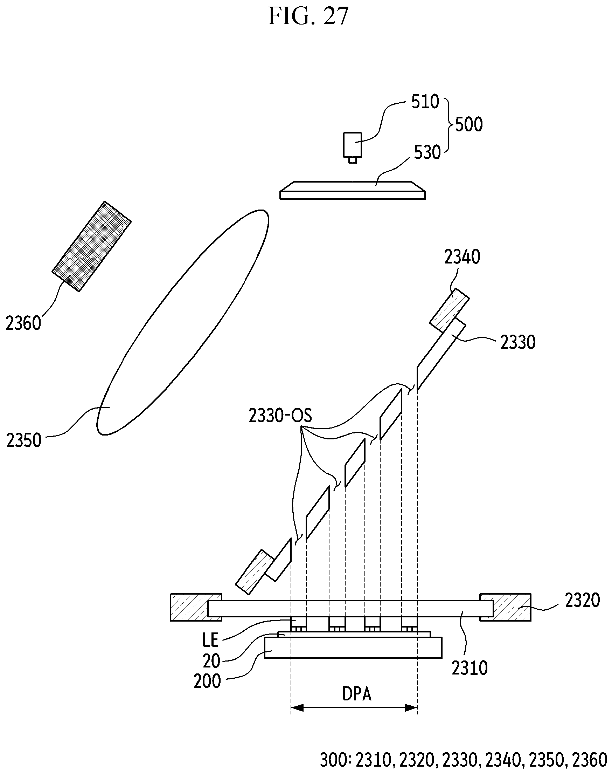

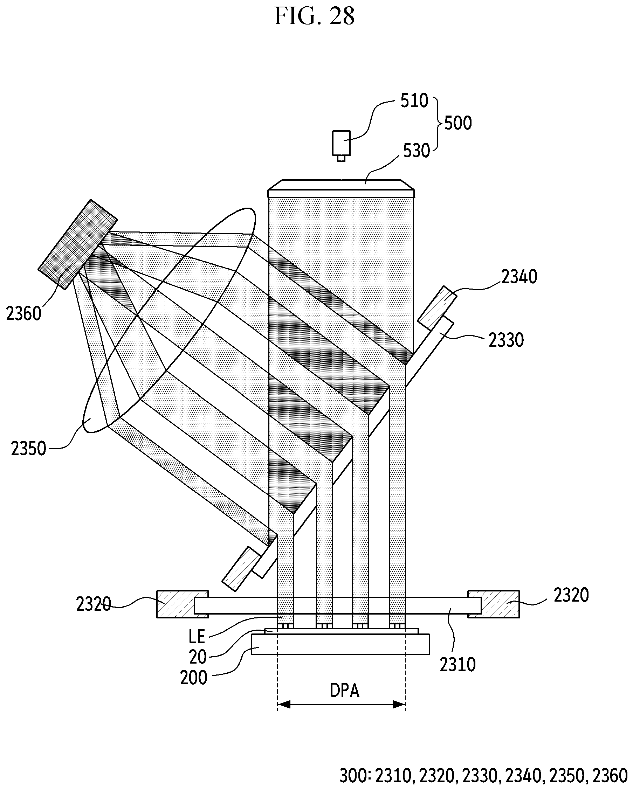

FIG. 27 is a side cross-sectional view schematically illustrating a manufacturing device for a display panel according to another embodiment. FIG. 28 is a side cross-sectional view illustrating a micro LED transfer method using a manufacturing device for a display panel of FIG. 27.

Referring to FIGS. 27 and 28, the manufacturing device for the display panel differs from FIGS. 24 and 25 in that the reflective mask 2330 has openings corresponding to areas between the light emitting elements LE, except for the areas corresponding to the light emitting elements LEs arranged on the display substrate 20. In the embodiments of FIGS. 27 and 28, descriptions overlapping with the embodiments of FIGS. 24 and 25 will be omitted.

The reflective mask 2330 may be a fine pattern mask disposed on one surface of the pressing plate 2310 and including a pattern having light blocking properties. The reflective mask 2330 may be disposed between the pressing plate 2310 and the laser irradiation portion 500. The reflective mask 2330 may be arranged such that the reflective mask 2330 is inclined with respect to the pressing plate 2310. For example, the reflective mask 2330 may be arranged such that the distance between the pressing plates 2310 increases from one end to the other end.

The reflective mask 2330 is not particularly limited to being a material that reflects laser light, but may be, for example, a metallic material such as, for example, aluminum or the like.

The reflective mask 2330 may have a larger area than the range of the laser emitted and radiated from the laser irradiation portion 500. The reflective mask 2330 may be disposed to overlap thicknesswise with the non-display area NDA, which is an outer area of the display substrate 20, except for the display area DPA of the display substrate 20 where the plurality of light emitting elements LE are arranged. Further, the openings 312-OS may be formed to correspond to areas between the light emitting elements LE, except for areas corresponding to the light emitting elements LE arranged on the display substrate 20 on the pressing plate 2310. In other words, the reflective mask 2330 may include openings 312-OS corresponding to the light emitting elements LE arranged on the display substrate 20.

The openings 312-OS of the reflective mask 2330 may be aligned and aligned to overlap the light emitting element LE in the thickness direction. Accordingly, the reflective mask 2330 may direct laser light to the light emitting elements LE arranged on the display substrate 20 (and not other portions of the display substrate 20) and prevent laser light from illuminating the display substrate 20 corresponding to the spacing between the light emitting elements LE.

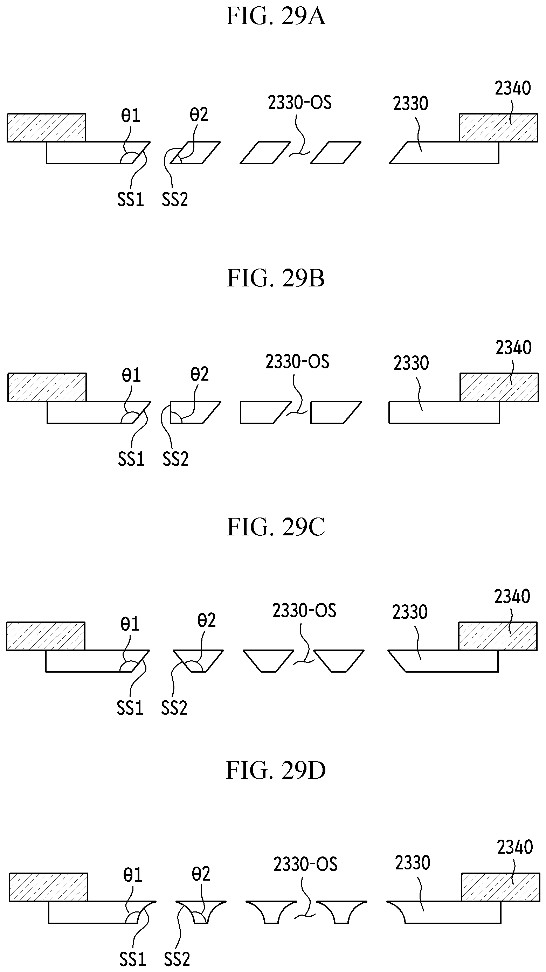

FIGS. 29a to 29d are cross-sectional views of a metal mask according to an embodiment of FIG. 27.

Referring to FIGS. 29a to 29d, the reflective mask 2330 has openings 2330-OS disposed in areas corresponding to the light emitting elements LE arranged on the display substrate 20. The side surfaces of the openings 2330-OS of the reflective mask 2330 may have a slope. Each of the openings 2330-OS of the reflective mask 2330 may have a first side SS1 and a second side SS2. The first side SS1 and the second side SS2 may face each other.

Referring to FIGS. 29a and 29b, the first angle θ1 formed between one side of the reflective mask 2330 and the first side SS1 and the second angle θ2 formed by one side of the reflective mask 2330 and the second side surface SS2 may be different from each other.

As illustrated in FIG. 29a, the first angle θ1 formed between one surface of the reflective mask 2330 and the first side surface SS1 may be an obtuse angle exceeding 90 degrees and the second angle θ2 formed between one side of the reflective mask 2330 and the second side surface SS2 may be an acute angle of less than 90 degrees. Alternatively, as illustrated in FIG. 29b, the first angle θ1 formed between one surface of the reflective mask 2330 and the first side S1 may be an obtuse angle exceeding 90 degrees and the second angle θ2 formed between one side of the reflective mask 2330 and the second side S2 may be a right angle.

Referring to FIGS. 29c and 29d, the first angle θ1 formed between one side of the reflective mask 2330 and the first side S1 and the second angle θ2 formed by one side of the reflective mask 2330 and the second side S2 may be the same. As illustrated in FIG. 29c, the first angle θ1 formed between one side of the reflective mask 2330 and the first side S1 and the second angle θ2 formed by one side of the reflective mask 2330 and the second side S2 may be the same as an obtuse angle exceeding 90 degrees. As illustrated in FIG. 29d, a first angle θ1 formed between one side of the reflective mask 2330 and the first side S1 and the second angle θ2 formed between one side of the reflective mask 2330 and the second side S2 is an obtuse angle exceeding 90 degrees, but the inclined surface may have a curvature. The slope may become gentler as the slope increases, but is not limited thereto.

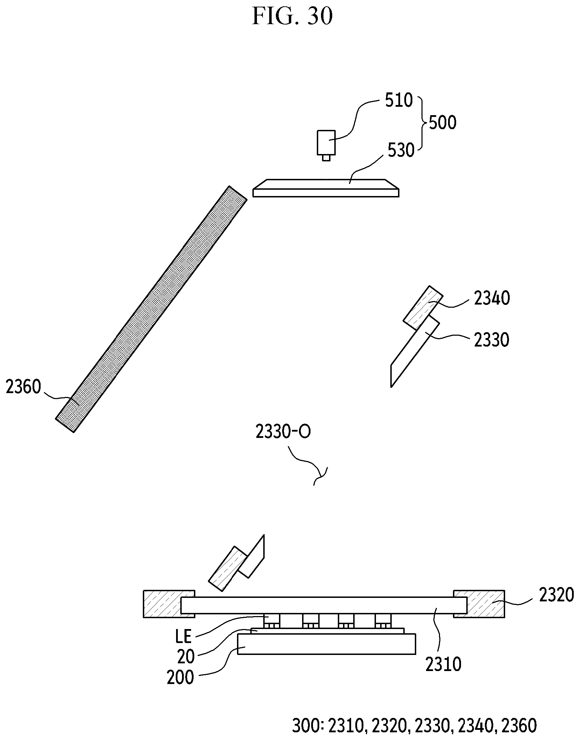

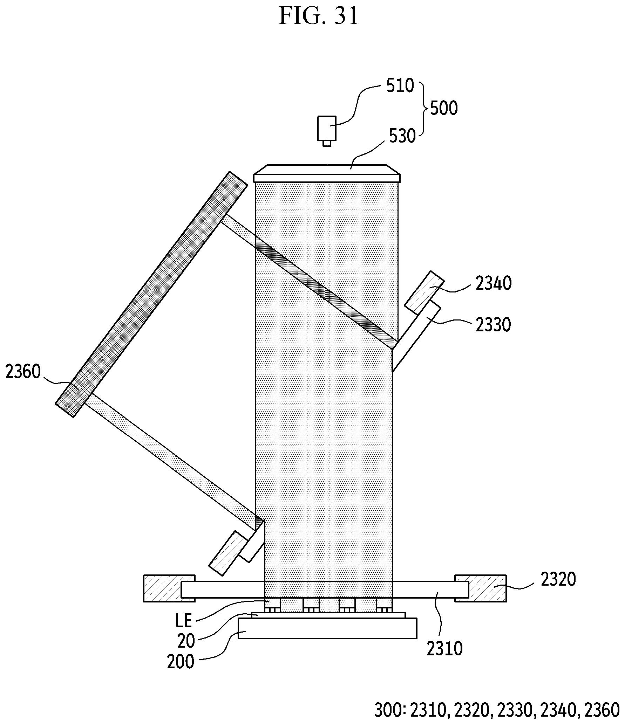

FIG. 30 is a side cross-sectional view schematically illustrating a manufacturing device for a display panel according to another embodiment. FIG. 31 is a side cross-sectional view illustrating a micro LED transfer method using a manufacturing device for a display panel of FIG. 30.

Referring to FIGS. 30 and 31, the manufacturing device for the display panel differs from FIGS. 24 and 25 in that the manufacturing device does not include the optical member 2350. Descriptions overlapping with the embodiments of FIGS. 24 and 25 will be omitted.

Referring to FIGS. 30 and 31, the light absorbing member 2360 absorbs the laser light reflected from the reflective mask 2330. The light absorbing member 2360 may be disposed at a preset inclination such that the light absorbing member 2360 faces the direction in which the reflective mask 2330 is disposed. For example, the light absorbing member 2360 is disposed on the path of light emitted from the laser irradiation portion 500 and reflected by the reflective mask 2330. The light absorbing member 2360 is disposed so as not to overlap the path of light emitted and radiated from the laser irradiation portion 500.

The light absorbing member 2360 may have a larger area than the opening 2330-O of the reflective mask 2330.

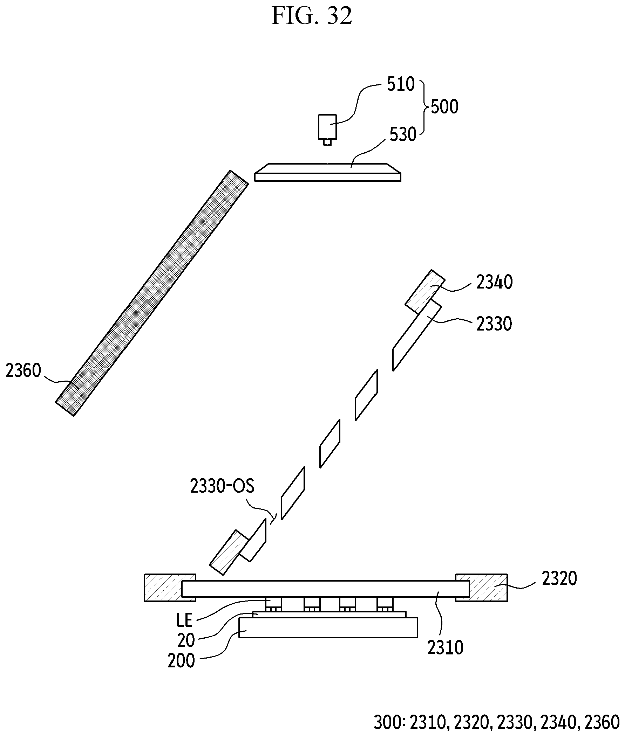

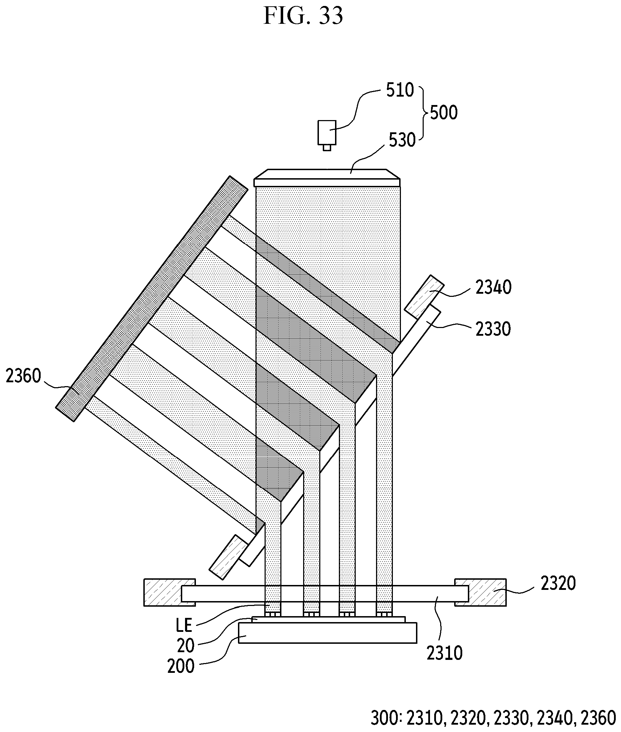

FIG. 32 is a side cross-sectional view schematically illustrating a manufacturing device for a display panel according to another embodiment. FIG. 33 is a side cross-sectional view illustrating a micro LED transfer method using a manufacturing device for a display panel of FIG. 32.

Referring to FIGS. 32 and 33, the manufacturing device for the display panel differs from FIGS. 30 and 31 in that the reflective mask 2330 has openings corresponding to areas between the light emitting elements LE, except for the areas corresponding to the light emitting elements LE arranged on the display substrate 20. In the embodiments of FIGS. 32 and 33, descriptions overlapping with the embodiments of FIGS. 30 and 31 will be omitted.

The reflective mask 2330 may be a fine pattern mask disposed on one surface of the pressing plate 2310 and including a pattern having light blocking properties. The reflective mask 2330 may be disposed between the pressing plate 2310 and the laser irradiation portion 500. The reflective mask 2330 may be disposed at a preset tilt with respect to the pressing plate 2310. For example, the reflective mask 2330 may be arranged such that the distance between the pressing plates 2310 increases from one end to the other end.

The reflective mask 2330 may have a larger area than the range of the laser emitted and radiated from the laser irradiation portion 500. The reflective mask 2330 may be disposed to overlap thicknesswise with the non-display area NDA, which is an outer area of the display substrate 20, except for the display area DPA of the display substrate 20 where the plurality of light emitting elements LE are arranged. Further, the openings 312-OS may be formed to correspond to areas between the light emitting elements LE, except for areas corresponding to the light emitting elements LE arranged on the display substrate 20 on the pressing plate 2310. In other words, the reflective mask 2330 may include openings 312-OS corresponding to the light emitting elements LE arranged on the display substrate 20.

The openings 312-OS of the reflective mask 2330 may be arranged in alignment with the light emitting elements LE in a thicknesswise overlapping manner. Accordingly, the reflective mask 2330 may direct laser light to the light emitting elements LE arranged on the display substrate 20 (and not other portions of the display substrate 20) and prevent laser light from illuminating the display substrate 20 corresponding to the spacing between the light emitting elements LE.

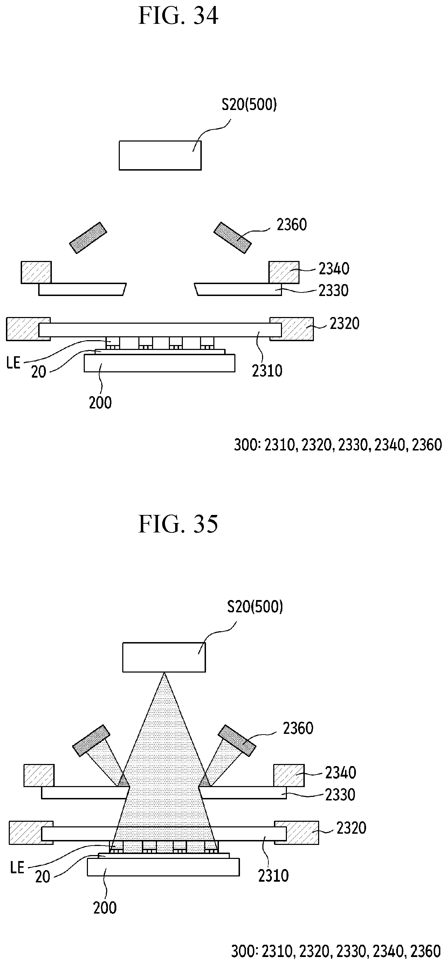

FIG. 34 is a side cross-sectional view schematically illustrating a manufacturing device for a display panel according to another embodiment. FIG. 35 is a side cross-sectional view illustrating a micro LED transfer method using a manufacturing device for a display panel of FIG. 34.

Referring to FIGS. 34 and 35, the device for manufacturing the display panel differs from FIGS. 24 and 25 in that the reflective mask 2330 is disposed parallel to the plate transfer member 2320, and the plurality of light absorbing members 2360 are disposed such that plurality of light absorbing members 2360 are inclined with respect to the reflective mask 2330 according to a preset tilt. In the embodiments of FIGS. 34 and 35, descriptions overlapping with the embodiments of FIGS. 24 and 25 will be omitted.

Referring to FIGS. 34 and 35, the laser irradiation portion 500 may radiate divergent light emitted from the laser light source 502 in various directions.

The pressing portion 300 may include a pressing plate 2310, a plate transfer member 2320 (also referred to herein as a plate transport member), a reflective mask 2330, a mask frame 2340, and a light absorbing member 2360. Since the pressing plate 2310 and the plate transfer member 2320 have been described with reference to FIGS. 24 and 25, detailed description will be omitted.

The reflective mask 2330 includes one opening 2330-O. The laser beam may pass through the opening 2330-O. Accordingly, the opening 2330-O may define a transmission area of the laser beam. Here, the light emitted and radiated from the laser irradiation portion 500 passes through the opening 2330-O of the display substrate 20 through the reflective mask 2330 and is applied to a plurality of light emitting elements LE arranged on the display substrate 20.

The reflective mask 2330 may be mounted on the pressing plate 2310 such that the reflective mask 2330 overlaps the pressing plate 2310 in the thickness direction. The reflective mask 2330 may be disposed to be spaced apart from the pressing plate 2310 but is not limited thereto.

The smaller the size of the opening 2330-O of the reflective mask 2330, the further the opening 2330-O may be disposed away from the pressing plate 2310 and closer to the laser irradiation portion 500.

The light absorbing member 2360 absorbs the laser light reflected from the reflective mask 2330. The light absorbing member 2360 may be disposed on the reflective mask 2330 by a mounting member.

The light absorbing member 2360 may be disposed at a preset inclination such that the light absorbing member 2360 faces the direction of travel of the laser light reflected from the reflective mask 2330 by the holding member.

Accordingly, the laser light applied to the reflective mask 2330 is reflected in the direction of the light absorbing member 2360. Accordingly, among the laser light emitted from the laser irradiation portion 500, the light transmitted through the openings of the reflective mask 2330 may be applied to the plurality of light emitting elements LE arranged on the display substrate 20. That is, the laser light that passes through the openings of the reflective mask 2330 may be applied to the plurality of light emitting elements LE arranged on the display substrate 20.

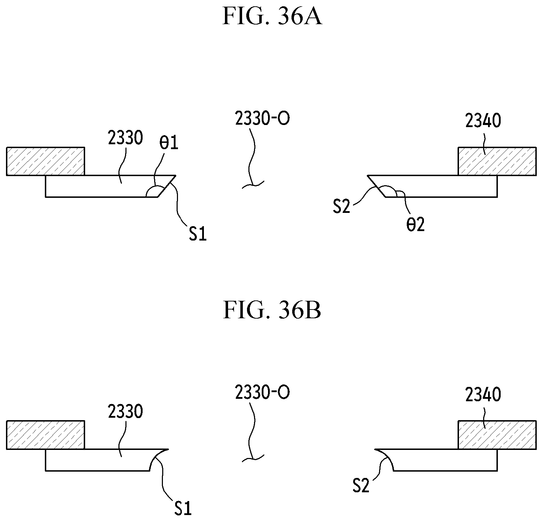

FIGS. 36a and 36b are cross-sectional views of s metal mask according to an embodiment of FIG. 33.

Referring to FIGS. 36a and 36b , a first angle θ1 formed by one side of the reflective mask 2330 and a first side S1 and a second angle θ2 formed by one side of the reflective mask 2330 and the second side S2 may be the same. As illustrated in FIG. 36a, a first angle θ1 formed between one side of the reflective mask 2330 and the first side S1 and a second angle θ2 formed by one side of the reflective mask 2330 and the second side S2 may be the same as an obtuse angle exceeding 90 degrees. As illustrated in FIG. 36b, a first angle θ1 formed between one side of the reflective mask 2330 and the first side S1 and a second angle θ2 formed between one side of the reflective mask 2330 and the second side S2 is an obtuse angle exceeding 90 degrees, but the inclined surface may have a curvature. The slope may become gentler as the slope increases but is not limited thereto.

However, the aspects of the disclosure are not restricted to the one set forth herein. The above and other aspects of the disclosure will become more apparent to one of daily skill in the art to which the disclosure pertains by referencing the appended claims.

## Claims

1. A device for manufacturing a display panel (10), the device comprising:
a support portion (200) on which a display substrate (20) is mounted;
a mask (310, 1310) defining an opening (312-O, 312-OS, 1312-OS) corresponding to a transmission area of a laser beam;
a pressing portion (300) comprising a pressing member (350) configured to press against the mask (310, 1310); and
a laser irradiation portion (500) disposed in a front surface of the support portion (200) and configured to irradiate the display substrate (20) with laser light through the mask (310, 1310).
wherein the mask (310, 1310) comprises:
a base layer (311, 1311) configured to transmit the laser light; and
a light blocking pattern layer (312, 1312) disposed on the base layer (311, 1311) and comprising the opening (312-O, 312-OS, 1312-OS).

2. The device of claim 1, wherein the pressing member (350) comprises a light transmitting member and an elastic member disposed on the mask (310, 1310) and overlapping each other in a thickness direction, forms a closed space (350-S) between the light transmitting member and the elastic member, and further comprises a gas pressure regulator (353) configured to adjust a gas pressure in the closed space (350-S).

3. The device of claim 2, wherein the pressing member (350) further comprises a gas conduit (354) connected between the gas pressure regulator (353) and the closed space (350-S).

4. The device of claim 2 or 3, wherein:
the elastic member is disposed on the mask (310, 1310), and
the elastic member is configured to expand based on an increase in gas pressure in the closed space (350-S), wherein expansion of the elastic member presses the mask (310, 1310).

5. The device of any one of the preceding claims, wherein the mask (310, 1310) is a photo mask (310) comprising:
the base layer (311) in a form of a transparent flat plate or a translucent flat plate; and
the light blocking pattern layer (312) having a light blocking pattern having light blocking properties.

6. The device of claim 5, wherein the photo mask (310) is disposed such that the photo mask (310) faces the display substrate (20).

7. The device of claim 5, wherein the photo mask (310) is disposed such that the photo mask (310) faces the laser irradiation portion.

8. The device of any one of claims 5 to 7,
wherein the light blocking pattern comprises openings (312-O, 312-OS) formed in an area corresponding to a display area (DPA) of the display substrate (20) where light emitting elements (LE) are arranged; or
wherein the light blocking pattern comprises openings (312-O, 312-OS) formed in areas corresponding to light emitting elements (LE) arranged on the display substrate (20).

9. The device of any one of the preceding claims, further comprising a mounting member (315, 1315) attached to an outer surface of the mask (310, 1310) and configured to support the mask (310, 1310).

10. The device of any one of claims 1 to **4,** wherein the mask (310, 1310) is a metal mask assembly (1310) comprising:
a light transmitting layer (1311) as the base layer (311, 1311) in a form of a transparent plate or a translucent flat plate; and
a metal mask (1312) as the light blocking pattern layer (312, 1312) disposed on the light transmitting layer (1311), having reflectivity, and comprising the opening (1312-OS).

11. The device of claim 10,
wherein the opening (1312-OS) is formed in an area corresponding to a display area (DPA) of the display substrate (20) where light emitting elements (LE) are arranged; or
wherein the opening (1312-OS) is respectively formed in areas corresponding to light emitting elements (LE) arranged on the display substrate (20).

12. A device for manufacturing a display panel (10), the device comprising:
a support portion (200) on which a display substrate (20) is mounted;
a light transmitting plate (351) disposed on a front surface of the support portion (200), a pressing member (350) configured to press against the light transmitting plate (351), a reflective mask (2330) defining an opening (2330-O, 2330-OS) corresponding to a transmission area of a laser beam incident on the light transmitting plate (351), and a pressing portion (300) comprising a light absorbing member (2360) configured to absorb laser light reflected by the reflective mask (2330); and
a laser irradiation portion (500) disposed in front of the light transmitting plate (351) and configured to irradiate the display substrate (20) with the laser light through the light transmitting plate (351);
wherein:
the reflective mask (2330) is disposed such that the reflective mask (2330) is inclined with respect to a top surface of the light transmitting plate (351), and
the light absorbing member (2360) is disposed parallel to the reflective mask (2330); or
the laser light is divergent light.

13. The device of claim 12, wherein:
the pressing portion (300) is disposed between the reflective mask (2330) and the light absorbing member (2360), and
the pressing portion (300) further comprises an optical member (2350) configured to focus light toward the light absorbing member (2360).

14. The device of claim 12 or 13,
wherein the opening (2330-O, 2330-OS) is formed in an area corresponding to a display area (DPA) of the display substrate (20) where light emitting elements (LE) are arranged; or
wherein the opening (2330-O, 2330-OS) is respectively formed in areas corresponding to light emitting elements (LE) arranged on the display substrate (20).

15. The device of any one of claims 12 to 14,
wherein the opening (2330-O, 2330-OS) comprises a first side and a second side facing the first side and is trapezoidal or parallelogram-shaped, and
a first angle formed by the first side and one side of the reflective mask (2330) and a second angle formed by the second side and the one side of the reflective mask (2330) are different from each other; or
wherein the opening (2330-O, 2330-OS) comprises a first side and a second side facing the first side, and
wherein:
a first angle formed by the first side and one side of the reflective mask (2330) and a second angle formed by the second side and the one side of the reflective mask (2330) are respectively the same as angles of an equilateral trapezoid, or
the first side and the second side each have a curvature.
